(19) Europäisches Patentamt
European Patent Office
Office européen des brevets

(11) EP 3 221 422 B1

(12) # EUROPÄISCHE PATENTSCHRIFT

(45) Veröffentlichungstag und Bekanntmachung des Hinweises auf die Patenterteilung:
**13.06.2018 Patentblatt 2018/24**

(21) Anmeldenummer: **15804337.2**

(22) Anmeldetag: **17.11.2015**

(51) Int Cl.:
***C09K 11/06*** *(2006.01)* ***H01L 51/00*** *(2006.01)*
***H01L 51/50*** *(2006.01)*

(86) Internationale Anmeldenummer:
**PCT/EP2015/076784**

(87) Internationale Veröffentlichungsnummer:
**WO 2016/079097 (26.05.2016 Gazette 2016/21)**

(54) **KUPFER(I)KOMPLEXE FÜR OPTOELEKTRONISCHE ANWENDUNGEN**
COPPER(I) COMPLEXES FOR OPTOELECTRONIC APPLICATIONS
COMPLEXES DE CUIVRE(I) POUR APPLICATIONS OPTOÉLECTRONIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.11.2014 EP 14193717**

(43) Veröffentlichungstag der Anmeldung:
**27.09.2017 Patentblatt 2017/39**

(73) Patentinhaber: **cynora GmbH**
**76646 Bruchsal (DE)**

(72) Erfinder:
- **VOLZ, Daniel**
**76131 Karlsruhe (DE)**
- **AMBROSEK, David**
**10437 Berlin (DE)**

(74) Vertreter: **Hoppe, Georg Johannes**
**Darani Anwaltskanzlei**
**Beuckestrasse 20**
**14163 Berlin (DE)**

(56) Entgegenhaltungen:
**EP-A1- 1 911 516** **EP-A1- 2 554 625**
**EP-A1- 2 594 571** **EP-A1- 2 729 477**
**WO-A1-2014/202675** **DE-A1-102013 100 181**

- **ASLANIDIS P ET AL: "Preparation and spectral studies of dinuclear mixed-ligand copper(I) complexes. The crystal structure of bis[mu-s(pyridine-2-thione)(tmtp) copper(I) bromide]", POLYHEDRON, PERGAMON PRESS, OXFORD, GB, Bd. 13, Nr. 22, 1. November 1994 (1994-11-01), Seiten 3119-3125, XP026638694, ISSN: 0277-5387, DOI: 10.1016/S0277-5387(00)83680-3 [gefunden am 1994-11-01]**
- **ESPINOZA SULLY ET AL: "The crystal structure of mono- and di-nuclear copper(I) complexes with substituted triphenylphosphine ligands", POLYHEDRON, PERGAMON PRESS, OXFORD, GB, Bd. 85, 4. September 2014 (2014-09-04), Seiten 405-411, XP029101998, ISSN: 0277-5387, DOI: 10.1016/J.POLY.2014.08.055**
- **DANIEL VOLZ ET AL: "Molecular Construction Kit for Tuning Solubility, Stability and Luminescence Properties: Heteroleptic MePyrPHOS-Copper Iodide-Complexes and their Application in Organic Light-Emitting Diodes", CHEMISTRY OF MATERIALS, AMERICAN CHEMICAL SOCIETY, WASHINGTON, DC, US, Bd. 25, Nr. 17, 1. Januar 2013 (2013-01-01), Seiten 3414-3426, XP002751587, ISSN: 1520-5002, DOI: 10.1021/CM4010807 [gefunden am 2013-07-16]**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Einleitung

Zurzeit zeichnet sich ein drastischer Wandel im Bereich der Bildschirm- und Beleuchtungstechnik ab. Es wird möglich sein, flache Displays oder Leuchtflächen mit einer Dicke von unter 0,5 mm zu fertigen. Diese sind durch viele faszinierende Eigenschaften ausgezeichnet. So werden z. B. Leuchtflächen als Tapeten mit sehr geringem Energieverbrauch realisierbar sein. Ferner werden Farbbildschirme mit bisher nicht erreichbarer Farb-Echtheit, Helligkeit und Blickwinkelunabhängigkeit, mit geringem Gewicht sowie sehr niedrigem Stromverbrauch herstellbar sein. Die Bildschirme werden sich als Mikro-Displays oder Großbildschirme mit mehreren Quadratmetern Fläche in starrer Form oder flexibel, aber auch als Transmissions- oder Reflexions-Displays gestalten lassen. Ferner wird es möglich sein, einfache und kostensparende Herstellungsverfahren wie Siebdruck oder Tintenstrahldruck oder Vakuum-Sublimation einzusetzen. Dadurch wird im Vergleich zu herkömmlichen Flachbildschirmen eine sehr preiswerte Fertigung ermöglicht. Diese Technik basiert auf dem Prinzip der **OLED**s, den **O**rganic **L**ight **E**mitting **D**iodes, die in Figur 1 schematisch und vereinfacht dargestellt ist.

Derartige Bauteile bestehen vorwiegend aus organischen Schichten, wie in Figur 1 schematisch und vereinfacht gezeigt ist. Bei einer Spannung von z. B. 5 V bis 10 V treten aus einer leitenden Metallschicht, z. B. aus einer Aluminium-Kathode, negative Elektronen in eine dünne Elektronen-Leitungsschicht und wandern in Richtung der positiven Anode. Diese besteht z. B. aus einer durchsichtigen, aber elektrisch leitenden, dünnen Indium-Zinn-OxidSchicht, von der positive Ladungsträger, sog. Löcher, in eine organische Löcher-Leitungsschicht einwandern. Diese Löcher bewegen sich im Vergleich zu den Elektronen in entgegengesetzter Richtung, und zwar auf die negative Kathode zu. In einer mittleren Schicht, der Emitterschicht, die ebenfalls aus einem organischen Material besteht, befinden sich zusätzlich besondere Emitter-Moleküle, an denen oder in deren Nähe die beiden Ladungsträger rekombinieren und dabei zu neutralen, aber energetisch angeregten Zuständen der Emitter-Moleküle führen. Die angeregten Zustände geben dann ihre Energie als helle Lichtemission ab, z. B. in blauer, grüner oder roter Farbe. Auch Weißlicht-Emission ist realisierbar. Auf die Emitterschicht kann gegebenenfalls auch verzichtet werden, wenn die Emittermoleküle sich in der Loch- oder Elektronen-Leitungsschicht befinden.

Die neuen OLED-Bauelemente lassen sich großflächig als Beleuchtungskörper oder auch äußerst klein als Pixel für Displays gestalten. Entscheidend für den Bau hoch-effektiver OLEDs sind die verwendeten Leuchtmaterialien (Emitter-Moleküle). Diese können in verschiedener Weise realisiert werden, und zwar unter Verwendung rein organischer oder metall-organischer Moleküle sowie von Komplexverbindungen. Es lässt sich zeigen, dass die Lichtausbeute der OLEDs mit metallorganischen Substanzen, den sog. Triplett-Emittern, wesentlich größer sein kann als für rein organische Materialien. Aufgrund dieser Eigenschaft kommt der Weiterentwicklung der metallorganischen Materialien ein wesentlicher Stellenwert zu. Die Funktion von OLEDs ist bereits sehr häufig beschrieben worden. (C. Adachi et al., Appl. Phys. Lett. 2001, 78, 1622; X. H. Yang et al., Appl. Phys. Lett. 2004, 84, 2476; J. Shinar (Hrsg.), Organic light-emitting devices - A survey, AIP-Press, Springer, New York, 2004; H. Yersin, Top. Curr. Chem. 2004, 241, 1; H. Yersin, Highly Efficient OLEDs with Phosphorescent Materials, Wiley-VCH, Weinheim 2008; Z. H. Kafafi, Organic Electroluminescence, Taylor & Francis, Boca Raton, 2005) Unter Einsatz von metallorganischen Komplexen mit hoher Emissionsquantenausbeute (Übergänge unter Einbeziehung der untersten Triplett-Zustände zu den Singulett-Grundzuständen) lässt sich eine besonders hohe Effizienz des Bauteils erzielen. Diese Materialien werden häufig als Triplett-Emitter oder phosphoreszierende Emitter bezeichnet.

Kupferkomplexe der Form $Cu_2X_2L_4$, $Cu_2X_2L'_2$ und $Cu_2X_2L_2L'$ (L = Phosphan-, Amin-, Imin-Ligand; L' = zweizähniger Phosphan-, Imin-, Amin-Ligand, s.u.) sind bereits im Stand der Technik bekannt. Sie zeigen intensive Lumineszenz bei Anregung mit UV-Licht. Die Lumineszenz kann entweder von einem MLCT- *(metal-to-ligand-charge-transfer)*, CC-(*cluster centered*)- oder XLCT (*halogen-to-ligand-charge-transfer*)-Zustand oder einer Kombination dieser stammen. Bei dem verwandten $[Cu_2X_2(PPh_3)_2nap]$-Komplex (nap = 1,8-Naphthyridin, X = Br, I) wird ein Übergang zwischen dem Molekülorbital der $\{Cu_2X_2\}$-Einheit (Cu d- und Halogen p-Orbitale) und den $\pi^*$-Orbitalen der nap-Gruppe diskutiert.

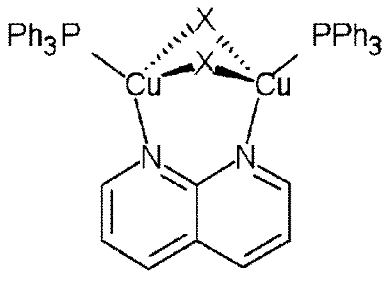

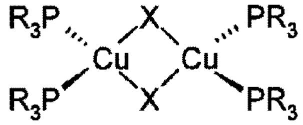

Beispiele der Komplexe der Form $Cu_2X_2L_4$ (L = $Cu_2X_2L_2L'$ (L = $PPh_3$, L' = 1,8-Naphthyridin, X $PR_3$, X = Cl, Br, oder I) = Br, I)

Triplett-Emitter weisen ein großes Potential zur Lichterzeugung in Displays (als Pixel) und in Beleuchtungsflächen (z. B. als Leuchttapete) auf. Sehr viele Triplett-Emitter-Materialien werden mittlerweile technologisch in Devices eingesetzt. Die bisherigen Lösungen weisen Nachteile auf, und zwar insbesondere in folgenden Bereichen:

- Langzeitstabilität der Emitter in den OLED-Devices,
- Thermische Stabilität,
- Chemische Stabilität gegenüber Wasser und Sauerstoff,
- Verfügbarkeit wichtiger Emissionsfarben,
- Fertigungstechnische Reproduzierbarkeit,
- Erreichbarkeit einer hohen Effizienz bei hohen Stromdichten,
- Erreichbarkeit sehr hoher Leuchtdichten,
- Hoher Preis der Emittermaterialien,
- Emittermaterialien sind toxisch und
- Synthesen sind aufwendig.

Die Verwendung von Emittern in hoher Dotierkonzentration wird häufig durch deren Unlöslichkeit, schlechte Filmbildungseigenschaften, Selbstaggregation sowie Kristallisation verhindert. Derartige Effekte sorgen dafür, dass in den Schichten der OLED Defekte entstehen, die Effizienz und Lebensdauer begrenzen. Vor diesem Hintergrund lag der vorliegenden Erfindung die Aufgabe zu Grunde, zumindest einige der oben genannten Nachteile zu überwinden.

**Beschreibung**

Es wurde gefunden, dass die Verwendung von bestimmten Kupfer(I)-komplexen mit Bis- und Tris-(Phenyl)-phosphinen und -arsinen, welche in meta-Position einen Methyl-, Ethyl-, n-Propyl-, i-Propyl-, t-Butyl-, n-Butyl-, i-Butyl- oder s-Butylsubstituenten aufweisen, die oben beschriebenen Probleme zumindest teilweise löst.

Die Erfindung betrifft positiv geladene oder neutrale ein- oder mehrkernige Kupfer(I)-komplexe aufweisend eine Struktur oder bestehend aus einer Struktur der allgemeinen Formel 1, die in optoelektronischen Bauteilen zum Transport von Ladung oder der Erzeugung von sichtbarem Licht eingesetzt und verwendet werden.

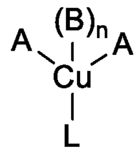

Formel 1

mit L: Ligand nach der Unterformel 1

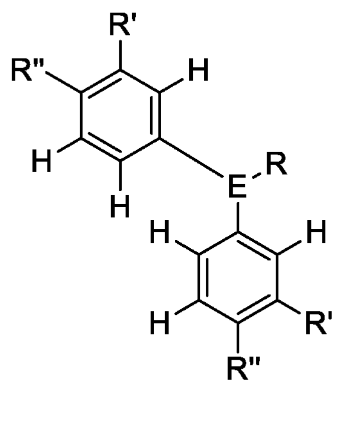

Unterformel 1

mit E: Arsen oder Phosphor;

mit R: R ist bei jedem Auftreten gleich oder verschieden, H, D, ein weiterer in meta-Position mit R' und optional in para-Position mit R" substituierter Phenylring oder Heteroarylring wie Pyridin eine geradkettige Alkyl-, Alkoxy- oder Thioalkylgruppe mit 1 bis 8 C-Atomen oder eine verzweigte oder cyclische Alkyl-, Alkoxy- oder Thioalkylgruppe mit 3 bis 8 C-Atomen oder eine Alkenyl- oder Alkinylgruppe mit 2 bis 8 C-Atomen, wobei die oben genannten Gruppen jeweils mit einem oder mehreren Resten R" substituiert sein können und wobei eine oder mehrere $CH_2$- Gruppen in den oben genannten Gruppen durch $-R^3C=CR^3-$, -C=C-, $Si(R^3)_2$, C=O, C=S, $C=NR^3$, -C(=O)O-, $-C(=O)NR^3-$, $NR^3$, $P(=O)(R^3)$, -O-, -S-, SO oder $SO_2$ ersetzt sein können und wobei ein oder mehrere H-Atome in den oben genannten Gruppen durch D ersetzt sein können, oder ein aromatisches Ringsystem mit 6 bis 30 aromatischen Ringatomen, das jeweils durch einen oder mehrere Reste R'" substituiert sein kann oder eine Aryloxygruppe mit 6 bis 30 aromatischen Ringatomen, die durch einen oder mehrere Reste R'" substituiert sein kann;

mit R': R' ist bei jedem Auftreten gleich oder verschieden, Methyl, Ethyl, n-Propyl, i-Propyl, t-Butyl, n-Butyl, i-Butyl, s-Butyl;

mit R": R" ist bei jedem Auftreten gleich oder verschieden H, D, einer geradkettige Alkyl-, Alkoxy- oder Thioalkylgruppe mit 1 bis 8 C-Atomen oder einer verzweigte oder cyclische Alkyl-, Alkoxy- oder Thioalkylgruppe mit 3 bis 8C-Atomen oder eine Alkenyl- oder Alkinylgruppe mit 2 bis 8 C-Atomen, Phenyl, Pyridyl, Aryl;

mit R''': ist bei jedem Auftreten gleich oder verschieden H, Alkyl (linear, insbesondere mit 1 bis 8 C-Atomen; verzweigt oder cyclisch, insbesondere mit 3 bis 8 C-Atomen) oder Aryl;

mit $R^3$: ist bei jedem Auftreten gleich oder verschieden H, Alkyl (linear, verzweigt oder cyclisch) oder Aryl;

mit n = 0 oder 1;

mit A, B: unabhängig voneinander ausgewähltes neutrales oder monoanionisches, koordinierendes Donoratom ausgewählt aus der Liste N, P, As, S, O, F, Cl, Br, I, Pseudohalogenid, welches optional auch Teil eines überbrückenden oder chelatisierenden mehrzähnigen Liganden sein kann. Bei Anwesenheit von B ist der Kupferkomplex CuLAAB tetraedrisch oder pseudotetraedrisch koordiniert, wohingegen bei optionaler Abwesenheit von B der resultierende Kupferkomplexe CuLAA verzerrt trigonal-planare Geometrie aufweist. Optional können die beiden A oder A und B oder A, A und B auch über eine Brücke miteinander verbunden sein, sodass mehrzähnige Liganden vorliegen, beispielsweise sog. NHetPHOS-Liganden (2-PR2-N-Heterozyklus), Naphthryridin, Bipyridin, 2-Diphenylphosphino-benzylamine.

Im Dokument D1 werden ähnliche Kupferkomplexe zur Verwendung in optoelektronischen Bauteilen offenbart (Verbindung 4e oder 2e, Anspruch 7). Kupferkomplexe gemäß Formel 1 sind im Stand der Technik in anderen technischen Gebieten bekannt, z.B. in Dokument D2 (Beispiel 56), D3 (Tabelle 1, Zusammenfassung), D4 (Seite 406, Verbindung CuBr[P(m-tolyl)3)3]) doch finden sich keine Hinweise darauf, dass sich diese zur Verwendung in einem optoelektronischen Bauteil eignen. In Dokument D5 (Anspruch 21; Seite 17) sind Kupfer(I)komplexe aufgeführt, die zur Umwandlung von blauem Licht in sichtbares Licht verwendet werden.

D1 EP 2 729 477 A1 (CYNORA GMBH [DE]) 14. Mai 2014 (2014-05-14)

D2 EP 1 911 516 A1 (TAKASAGO PERFUMERY CO LTD [JP]) 16. April 2008 (2008-04-16)

D3 ASLANIDIS P ET AL: "Preparation and spectral studies of dinuclear mixed-ligand copper(I) complexes. The crystal structure of bis[mu-s(pyridine-2-thione)(tmtp) copper(I) bromide]", POLYHEDRON, PERGAMON PRESS, OXFORD, GB, Bd. 13, Nr. 22, 1. November 1994 (1994-11-01), Seiten 3119-3125, ISSN: 0277-5387, DOI: 10.1016/S0277-5387(00)83680-3 [gefunden am 1994-11-01]

D4 ESPINOZA SULLY ET AL: "The crystal structure of mono- and di-nuclear copper(I) complexes with substituted triphenylphosphine ligands", POLYHEDRON, PERGAMON PRESS, OXFORD, GB, Bd. 85, 4. September 2014 (2014-09-04), Seiten 405-411, ISSN: 0277-5387, DOI: 10.1016/J.POLY.2014.08.055

D5 EP 2 594 571 A1 (CYNORA GMBH [DE]) 22. Mai 2013 (2013-05-22)

In einer bevorzugten Ausführungsform werden Kupfer(I)komplexe der Formel 1 verwendet, welche in einer Ausführungsform nach dem TADF-Mechanismus emittieren (Thermisch Aktivierte Verzögerte Fluoreszenz, EP2554625 A1). Die Emission nach dem TADF-Mechanismus kann auftreten, wenn die Metallkomplexe über einen besonders niedrigen Abstand der Singulett- und Triplett-Niveaus verfügen. Ist dies der Fall kann bei optischer oder elektrischer Anregung der Kupfer(I)komplexe eine thermische Rückbesetzung des $S_1$-Zustandes aus dem $T_1$-Zustand gemäß einer Boltzmann-Verteilung bzw. gemäß der thermischen Energie $k_BT$ erfolgen. Durch diesen Prozess wird aus dem besetzten

Triplett $T_1$ ein Emissionskanal über den Singulett-Zustand $S_1$ geöffnet. Da der Übergang aus dem $S_1$- in den $S_0$- Zustand stark erlaubt ist, wird auch die in den Triplett-Zustand gelangende Anregung praktisch vollständig als Lichtemission über den Singulett-Zustand abgestrahlt. In einer Ausführungsform sind A und B unabhängig voneinander ausgewählt ein neutrales oder monoanionisches, koordinierendes Donoratom ausgewählt aus der Liste N, P, As, S, O, F, Cl, Br, I, Pseudohalogenid, welches optional auch Teil eines überbrückenden oder chelatisierenden mehrzähnigen Liganden ist, und wobei mindestens einer der Liganden A oder B ungleich F, Cl, Br, I, oder Pseudohalogenid ist.
In einer speziellen Ausführungsform werden solche Komplexe nach Formel 1 verwendet, in denen L außerdem der Unterformel 2 genügt und für E, R und R' die bei Unterformel 1 angegebenen Definitionen gelten.

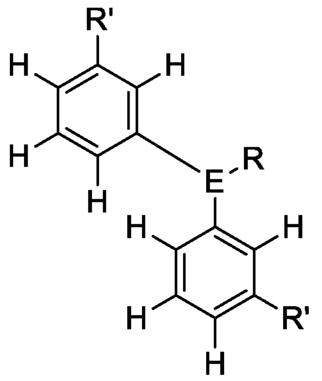

Unterformel 2

In einer speziellen Ausführungsform werden solche Komplexe nach Formel 1 verwendet, in denen L außerdem der Unterformel 3 genügt und für R und R' die bei Unterformel 1 angegebenen Definitionen gelten.

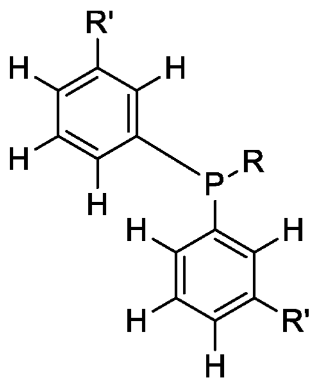

Unterformel 3

In einer Ausführungsform der Erfindung werden solche Komplexe nach Formel 1 verwendet, in denen L außerdem der Unterformel 4 genügt und für R' die bei Unterformel 1 angegebene Definition gilt.

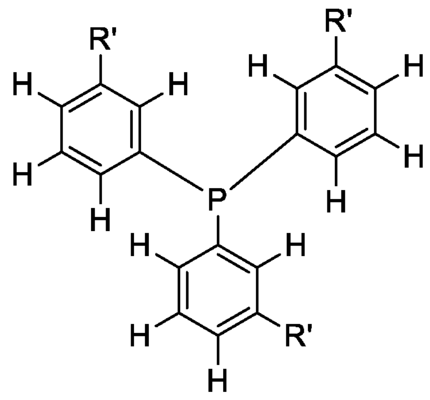

Unterformel 4

Die oben beschriebenen Komplexe gemäß Formel 1 bzw. die oben aufgeführten bevorzugten Ausführungsformen werden in der organischen Elektrolumineszenzvorrichtung als aktive Komponente verwendet. Aktive Komponenten sind generell die organischen, metallorganischen oder anorganischen Materialien, welche zwischen Anode und Kathode eingebracht sind, beispielsweise Ladungsinjektions-, Ladungstransport- oder Ladungsblockiermaterialien, Emissionsmaterialien und Matrixmaterialien. Insbesondere als Emissionsmaterialien zeigen die erfindungsgemäßen Verbindungen besonders gute Eigenschaften, wie im Folgenden noch näher ausgeführt wird. Eine bevorzugte Ausführungsform der Erfindung sind daher organische Elektrolumineszenzvorrichtungen enthaltend mindestens eine Verbindung gemäß Formel A in einer Emissionsschicht.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Ladungserzeugungsschichten (Charge Generation Layers) und/oder organische oder anorganische p/n-Übergänge. Ebenso können zwischen zwei emittierende Schichten Interlayers eingebracht sein, welche beispielsweise eine Exzitonenblockierende Funktion aufweisen. Es sei aber darauf hingewiesen, dass nicht notwendigerweise jede dieser Schichten vorhanden sein muss. Dabei kann die organische Elektrolumineszenzvorrichtung eine emittierende Schicht enthalten, oder sie kann mehrere emittierende Schichten enthalten, wobei mindestens eine emittierende Schicht mindestens eine Verbindung gemäß Formel 1 enthält. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die eine thermisch aktivierte verzögerte Fluoreszenz zeigen. Insbesondere bevorzugt sind Dreischichtsysteme, wobei die drei Schichten blaue, grüne und orange oder rote Emission zeigen (für den prinzipiellen Aufbau siehe z. B. WO 05/011013).

Wenn die Verbindung gemäß Formel 1 als emittierende Verbindung in einer emittierenden Schicht eingesetzt wird, wird sie bevorzugt in Kombination mit einem oder mehreren Matrixmaterialien eingesetzt. Die Mischung aus der Verbindung gemäß Formel 1 und dem Matrixmaterial enthält zwischen 1 und 99 Vol.-%, vorzugsweise zwischen 2 und 90 Vol.-%, besonders bevorzugt zwischen 4 und 85 Vol.-%, insbesondere zwischen 5 und 80 Vol.-% der Verbindung gemäß Formel 1 bezogen auf die Gesamtmischung aus Emitter und Matrixmaterial. Entsprechend enthält die Mischung zwischen 99 und 1 Vol.-%, vorzugsweise zwischen 98 und 10 Vol.-%, besonders bevorzugt zwischen 96 und 15 Vol.-%, insbesondere zwischen 95 und 20 Vol.-% des Matrixmaterials bezogen auf die Gesamtmischung aus Emitter und Matrixmaterial.

Da die Verbindungen gemäß Formel 1 im Allgemeinen hohe Glasübergangstemperaturen aufweisen, eignen sie sich weiterhin auch zum Einsatz als Reinschicht ohne die Verwendung eines Matrixmaterials. Somit enthält die emittierende Schicht in einer bevorzugten Ausführungsform ausschließlich die Verbindung gemäß Formel 1, d.h. in einer Konzentration von 100 %, und somit keinerlei weiteres Matrixmaterial.

Geeignete Matrixmaterialien sind Ketone, Phosphinoxide, Sulfoxide und Sulfone, z. B. gemäß WO 04/013080 A, WO 04/093207 A, WO 06/005627 A, Triarylamine, Carbazolderivate, z. B. CBP (N,N-Biscarbazolylbiphenyl) oder die in WO 05/039246 A, US 2005/0069729, JP 2004/288381, EP 1205527 oder WO 08/086851 A offenbarten Carbazolderivate, Indolocarbazolderivate, z. B. gemäß WO 07/063754 oder WO 08/056746 A, Azacarbazole, z. B. gemäß EP 1617710, EP 1617711 , EP 1731584, JP 2005/347160, bipolare Matrixmaterialien, z. B. gemäß WO 07/137725, Silane, z. B. gemäß WO 05/111172, Azaborole oder Boronester, z. B. gemäß WO 06/117052, Triazinderivate, z. B. gemäß DE 10 2008 036 982 A1, WO 07/063754 oder WO 08/056746, oder Zinkkomplexe, z. B. gemäß EP 652273 oder gemäß DE 10 2007 053 771 A1. Es kann auch bevorzugt sein, eine Mischung aus mehreren Matrixmaterialien als gemischte

Matrix für die Verbindung gemäß Formel 1 zu verwenden. Besonders bevorzugt hat eine Komponente der Matrix dann elektronenleitende Eigenschaften, ist also beispielsweise ein aromatisches Keton oder ein Triazinderivat, und die andere Komponente der Matrix hat lochleitende Eigenschaften, ist also beispielsweise ein Carbazolderivat oder ein Arylamin.

In einer weiteren bevorzugten Ausführungsform der Erfindung wird die Verbindung der Formel 1 als Co-Host für eine weitere lumineszierende Verbindung, die bei längerer Wellenlänge emittiert, verwendet. Dabei können als lumineszierende Verbindung, welche bei längerer Wellenlänge emittiert, generell alle lumineszierende Materialien, wie sie gemäß dem Stand der Technik bekannt sind, verwendet werden. So kann eine Verbindung der Formel 1, welche im blauen Bereich emittiert, als Co-Host für eine grün lumineszierende Verbindung eingesetzt werden und eine Verbindung, welche im grünen Bereich emittiert, als Co-Host für eine rot lumineszierende Verbindung. Als weiterer Co-Host wird besonders bevorzugt ein elektronenleitendes Matrixmaterial eingesetzt. Ein solcher Device-Aufbau ist beispielsweise allgemein in der Anmeldung DE 10 2008 063 470 A1 offenbart.

Die Erfindung betrifft in einer Ausführungsform eine organische Elektrolumineszenzvorrichtung und ein Verfahren zu deren Herstellung, bei der eine oder mehrere Schichten mit einem Sublimationsverfahren beschichtet werden. Dabei werden die Materialien in Vakuum-Sublimationsanlagen bei einem Anfangsdruck kleiner $10^{-5}$ mbar, bevorzugt kleiner $10^{-6}$ mbar aufgedampft. Es ist auch möglich, dass der Anfangsdruck noch geringer ist, beispielsweise kleiner $10^{-7}$ mbar.

Die Erfindung betrifft in einer weiteren Ausführungsform eine organische Elektrolumineszenzvorrichtung und ein Verfahren zu deren Herstellung, bei der eine oder mehrere Schichten mit einem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Die Erfindung betrifft auch eine organische Elektrolumineszenzvorrichtung und ein Verfahren zu deren Herstellung, bei der eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light Induced Thermal Imaging, Thermotransferdruck) oder InkJet Druck (Tintenstrahldruck), hergestellt werden. Da die Verbindungen gemäß Formel 1 im Allgemeinen eine gute Löslichkeit in den gängigen organischen Lösemitteln aufweisen, eignen sie sich gut für die Verarbeitung aus Lösung. Diese Verfahren sind dem Fachmann generell bekannt und können von ihm ohne Probleme auf organische Elektrolumineszenzvorrichtungen enthaltend Verbindungen gemäß Formel 1 bzw. die oben aufgeführten bevorzugten Ausführungsformen angewandt werden.

Ein Schlüsselschritt der Erfindung ist die gezielte Einführung von wenigen, kurzkettigen Alkylresten in Arylphosphinen und -arsinen in der 3-Position der Arylringe, die den Emittern zusätzliche Asymmetrie verleihen. Ein denkbarer Substituent ist m-Tolyl. Durch Verwendung von $P(m\text{-Tol})_3$ steigt infolge der Möglichkeit der Ausbildung von nichtäquivalenten Konformeren die Konformationsentropie (Figur 2), da es pro unsymmetrischer Tolylgruppe zwei verschiedene Möglichkeiten gibt, diese räumlich anzuordnen. Diese Möglichkeit der zusätzlichen Konformere treten bei symmetrischen Resten wie p-Tolyl nicht auf, während ebenfalls prinzipiell unsymmetrische Phosphinreste wie o-Tolyl aufgrund der dem Fachmann bekannten, hohen sterischen Abstoßung verstärkt zur Abspaltung aus der Koordinationssphäre von Metallkomplexen neigen und daher nicht geeignet sind. Ebenfalls wichtig ist es nur einen derartigen Rest einzuführen; während m-Tolyl (=3-Methyl-phenyl) ein unsymmetrischer Rest gemäß der vorliegenden Erfindung (Formel 1, Figur 2) ist, stellt 3,5-Dimethyl-phenyl einen symmetrischen Rest dar, bei dem keine zusätzlichen konformativen Freiheitsgrade vorliegen.

Derartige Effekte lassen sich auch quantifizieren: Hierbei werden Effekte wie die Konfigurations- bzw. Konformationsentrophie betrachtet, die bisher vor allem zur Erklärung von Morphologieeffekten in Makromolekülen (Proteine, DNS, RNS, künstliche Polymere) verwendet wird. Derartige Theorien, wie etwa die Flory-Huggins-Theorie, sind dem Fachmann bekannt.

Die Entropie S lässt sich allgemein mit der Gleichung

$$S = -R \sum(\ln W)$$

als Funktion der Zahl der Freiheitsgrade W beschreiben, wenn man annimmt, dass die Wahrscheinlichkeit zur Ausbildung aller Konformere annähernd gleich ist. Dies kann für $P(m\text{Tol})_3$ angenommen werden, da sich die Methylgruppen in einem hinreichend großen Abstand von der Koordinationsstelle des Donorphosphors befinden.

Vergleicht man nun den symmetrischen Liganden $P(\text{p-Tol})_3$ mit dem unsymmetrischen $P(\text{m-Tol})_3$, so ergeben sich durch die $2^3 = 8$ zusätzlichen Freiheitsgrade der Konformation ein zusätzlicher Entropiebeitrag von $\Delta S = 7.1\ J\ mol^{-1}\ K^{-1}$ (Beispiel 10). In der Realität kommen durch zusätzliche Freiheitsgrade der Drehung und Vibration je nach vorliegender Temperatur noch weitere Freiheitsgrade hinzu, sodass dieser Zahlenwert die Untergrenze für die konformative Stabilisierung darstellt.

Von besonderer Relevanz ist die Tatsache, dass die eingeführten Reste nicht von beliebiger Länge gewählt werden sollten, da eine hohe Zahl von langen Alkylketten die Morphologie negativ beeinflussen: Der Glasübergangspunkt sinkt bei langen Ketten stark ab, sodass die Morphologie von Funktionsschichten nicht länger stabil ist. Außerdem steigt der mittlere Abstand zwischen den Molekülen durch sterische Abstoßung, was in optoelektronischen Bauteilen sowohl die Übertragung von Ladung als auch die Übertragung von Energie negativ beeinflusst. Dies äußert sich beispielsweise in einer reduzierten Photolumineszenzquantenausbeute, was auf geringe Rigidität aufgrund des vergrößerten mittleren Abstandes zurück zu führen ist. Einige Beispiele für nicht-erfindungsgemäße Verbindungen, die aufgrund zu geringer Rigidität in Pulver sowie Filmzustand über Quanteneffizienzen von teilweise unter 60 % aufweisen, sind beispielsweise in Volz, D.; Zink, D. M.; Bocksrocker, T.; Friedrichs, J.; Nieger, M.; Baumann, T.; Lemmer, U.; Bräse, S. Chem. Mater. 2013, 25, 3414 aufgeführt. Dagegen zeigt die erfindungsgemäße Verbindung 1-I-s (siehe Beispiele) eine Quanteneffizienz von größer 90 % in Film und Pulver, wobei es nahezu zu keinem Farbshift bei der Herstellung der Filme kommt. Statt der Einführung von langen (symmetrischen) Alkylresten wie in Liganden wie dem Tris-n-octyl-phosphin ist die Einführung von mehreren sehr kurzen, unsymmetrisch eingebrachten Ketten günstiger für die Performance der Materialien.

Ein weiterer Vorteil der sich durch Verwendung der hier beschriebenen Liganden ergibt, ist eine Erhöhung der Standardbildungsentropie der Komplexe durch den zusätzlichen Beitrag der Konformation (Figur 3). Auch hier können pro zusätzlichem Freiheitsgrad zusätzliche Beiträge an Entropie generiert werden. Durch diese kann die Stabilität in Lösung signifikant erhöht werden (Beispiel 1).

Neben der hohen Stabilität in Lösung wird durch die Möglichkeit der unterschiedlichen Konformere die Ausbildung von Kristallisation effektiv verhindert. Dies äußert sich beispielsweise darin, dass selbst bei sorgfältiger Kristallzucht oft die Tolylreste fehlgeordnet vorliegen. Bei der Herstellung von Dünnfilmen wird somit keine Kristallisation auftreten und stattdessen auch beim Eindotieren in Hostmaterialien mit hoher Kristallisationstendenz ein amorpher Zustand eintreten.

Ferner wird durch die herabgesetzte Neigung zur Kristallisation und der hohen Standardbildungsentropie die Löslichkeit trotz des Vorliegens vergleichbar kurzer Alkylketten extrem herauf gesetzt. Der Grund hierfür liegt in der Herabsetzung der Gitterenergie durch die unsymmetrischen Reste sowie die hohe entropische Bevorzugung des amorphen Zustandes, welche durch die reduzierte/schwache Gitterenerige nicht mehr überkompensiert werden kann. Die Löslichkeit für die Verbindung 1-I-s ist in den Beispielen für verschiedene für die Flüssigprozessierung relevante Lösungsmittel tabellarisch aufgeführt.

Ein weiterer Vorteil der unsymmetrischen Methylgruppen ist deren Wirkung als sterisch anspruchsvolle Gruppe: Im Gegensatz zu Gruppen wie p-Tolyl reduzieren sie die Rotationsmöglichkeiten um die P-$C_{Aryl}$-Achse. Bei Anregung kann sich die Geometrie der Moleküle so weniger stark verzerren, sodass nicht-strahlende Relaxationspfade aus dem angeregten Zustand in den elektronischen Grundzustand reduziert werden. Dies äußert sich in einem geringen Shift beim Vergleich von Pulverproben und Dünnfilmen sowie einer hohen Quanteneffizienz (siehe Beispiele).

Die Liganden L werden in Kupferkomplexen nach Formel 1 eingesetzt, die insbesondere nach dem Singlet-Harvesting Mechanismus (TADF, thermisch aktivierte verzögerte Fluoreszenz) emittieren. Aus diesem Grund können bei Verwendung dieser Komplexe als Emitter in OLEDs besonders hohe Quanteneffizienzen und Helligkeiten erreicht werden, auch wenn die Dotierkonzentrationen in der Emissionsschicht höher als 5 Gewichtsprozent sind.

In einer Ausführungsform betrifft die Erfindung die Verwendung des Kupfer(I)komplexes der Formel 1 als Emitter oder Absorber in einem optoelektronischen Bauelement, das durch ein Vakuumverdampfungsverfahren oder aus Lösung hergestellt wird, wobei das optoelektronischen Bauelement insbesondere ausgewählt ist aus der Gruppe bestehend aus:

- Organischen Licht-emittierenden Dioden (OLEDs),
- Licht-emittierenden elektrochemischen Zellen,
- OLED-Sensoren, insbesondere in nicht hermetisch nach außen abgeschirmten Gas- und Dampf-Sensoren,
- organischen Solarzellen,
- Organischen Feldeffekttransistoren,
- Organischen Lasern und
- Down-Konversions-Elementen.

In einer weiteren Ausführungsform beträgt der Anteil des Kupfer(I)komplexes am Emitter oder Absorber 100 %.

In einer weiteren Ausführungsform beträgt der Anteil des Kupfer(I)komplexes als Emissionsmaterial in einer

Emissionsschicht oder als Absorber 1 % bis 99 %, wobei der Anteil des Kupfer(I)komplexes als Emitter in optischen Licht emittierenden Bauelementen, insbesondere in OLEDs, insbesondere zwischen 5 % und 80 % beträgt.

Die Erfindung betrifft auch optoelektronische Bauelemente, aufweisend einen Kupfer(I)komplex der Formel 1, wobei das optoelektronische Bauelement optional ausgeformt ist als ein Bauelement ausgewählt aus der Gruppe bestehend aus organischem lichtemittierendem Bauelement, organischer Diode, organischer Solarzelle, organischem Transistor, organischer lichtemittierender Diode, Licht-emittierender elektrochemischer Zelle, organischem Feldeffekttransistor und organischem Laser.

In einer Ausführungsform des optoelektronischen Bauelements wird die Verbindung gemäß Formel 1 als Emissionsmaterial in einer Emissionsschicht eingesetzt wird, wobei sie entweder in Kombination mit einem Matrixmaterial oder bevorzugt als Reinschicht eingesetzt werden kann. Dabei ist das Matrixmaterial in einer Ausführungsform ausgewählt aus der Gruppe bestehend aus Ketonen, Phosphinoxiden, Sulfoxiden, Sulfonen, Triarylaminen, Carbazolderivaten, Phenoxazinderivaten, Phenothiazinderivaten, Indolocarbazolderivaten, Azacarbazolen, bipolaren Matrixmaterialien, Silanen, Azaborolen, Boronestern, Triazinderivaten und Zinkkomplexen.

In einer weiteren Ausführungsform des optoelektronischen Bauelements beträgt der Anteil der Verbindung gemäß Formel 1 als Emissionsmaterial in einer Emissionsschicht in optischen Licht emittierenden Bauelementen, insbesondere in OLEDs, von 5 % bis 80 %.

Die Erfindung betrifft in einer weiteren Ausführungsform ein optoelektronisches Bauelement, aufweisend ein Substrat, und mindestens eine lichtemittierende Schicht, die eine Verbindung gemäß Formel 1 aufweist, wobei die lichtemittierende Schicht auf das Substrat aufgebracht ist.

Das erfindungsgemäße optoelektronische Bauelement weist in einer weiteren Ausführungsform ein Substrat, eine Anode, eine Kathode und mindestens eine lichtemittierende Schicht auf, die eine Verbindung gemäß Formel 1 aufweist, wobei die Anode und die Kathode auf das Substrat aufgebracht wird, und die lichtemittierende Schicht zwischen Anode und Kathode aufgebracht wird.

In einer weiteren Ausführungsform weist das erfindungsgemäße optoelektronische Bauelement ein Substrat, eine Anode, eine Kathode und mindestens eine lichtemittierende Schicht auf, die ausschließlich eine Verbindung gemäß Formel 1 in 100% Konzentration aufweist, wobei die Anode und die Kathode auf das Substrat aufgebracht ist, und die lichtemittierende Schicht zwischen Anode und Kathode aufgebracht ist.

Das erfindungsgemäße optoelektronische Bauelement kann in einer Ausführungsform ein Substrat, eine Anode, eine Kathode und mindestens eine lichtemittierende Schicht aufweisen, die eine Verbindung gemäß Formel 1 und ein Hostmaterial umfasst, dessen Triplett (T1)- und Singulett (S1)-Energieniveaus energetisch höher liegen als die Triplett (T1)- und Singulett (S1)-Energieniveaus der Verbindung gemäß Formel 1, wobei die Anode und die Kathode auf das Substrat aufgebracht wird, und die lichtemittierende Schicht zwischen Anode und Kathode aufgebracht wird.

In einer Ausführungsform weist das erfindungsgemäße optoelektronische Bauelement ein Substrat, eine Anode, eine Kathode und mindestens je eine löcher- und elektroneninjizierende Schicht, und mindestens je eine löcher- und elektronentransportierende Schicht, und mindestens eine lichtemittierende Schicht auf, die eine Verbindung gemäß Formel 1 und ein Hostmaterial aufweist, dessen Triplett (T1)- und Singulett (S1)-Energieniveaus energetisch höher liegen als die Triplett (T1)- und Singulett (S1)-Energieniveaus der Verbindung gemäß Formel 1, wobei die Anode und die Kathode auf das Substrat aufgebracht wird, und die löcher- und elektroneninjizierende Schicht zwischen Anode und Kathode aufgebracht wird, und die löcher- und elektronentransportierende Schicht zwischen löcher- und elektroneninjizierende Schicht aufgebracht wird, und die lichtemittierende Schicht zwischen löcher- und elektronentransportierende Schicht aufgebracht wird.

Das erfindungsgemäße optoelektronische Bauelement weist in einer weiteren Ausführungsform ein Substrat, eine Anode, eine Kathode und mindestens je eine löcher- und elektroneninjizierende Schicht, und mindestens je eine löcher- und elektronentransportierende Schicht, und mindestens eine lichtemittierende Schicht auf, die eine Verbindung gemäß Formel 1 und ein Hostmaterial aufweist, dessen Triplett (T1)- und Singulett (S1)-Energieniveaus energetisch höher liegen als die Triplett (T1)- und Singulett (S1)-Energieniveaus der Verbindung gemäß Formel 1, wobei die Anode und die Kathode auf das Substrat aufgebracht wird, und die löcher- und elektroneninjizierende Schicht zwischen Anode und Kathode aufgebracht wird, und die löcher- und elektronentransportierende Schicht zwischen löcher- und elektroneninjizierende Schicht aufgebracht wird, und die lichtemittierende Schicht zwischen löcher- und elektronentransportierende Schicht aufgebracht wird.

Die Erfindung betrifft in einem weiteren Aspekt ein lichtemittierendes Material, aufweisend eine Verbindung gemäß Formel 1 und ein Hostmaterial, wobei die Triplett (T1)- und Singulett (S1)-Energieniveaus des Hostmaterials energetisch höher liegen als die Triplett (T1)- und Singulett (S1)-Energieniveaus der Verbindung gemäß Formel 1, und wobei das lichtemittierende Material Fluoreszenz oder thermisch aktivierte verzögerte Fluoreszenz emittiert, und einen deltaE(S1-T1)-Wert zwischen dem untersten angeregten Singulett (S1)- und dem darunter liegenden Triplett (T1)-Zustand von kleiner als 2000 $cm^{-1}$ aufweist.

In einem weiteren Aspekt betrifft die Erfindung ein Verfahren zur Herstellung eines optoelektronischen Bauelements, wobei ein Kupfer(I)komplex der Formel 1 bzw. eine der hier beschriebenen Ausführungsformenen dieses

Kupfer(I)komplexes verwendet wird.

In einer Ausführungsform dieses Verfahrens erfolgt das Aufbringen des Kupfer(I)komplexes auf einen Träger nass-chemisch, mittels kolloidaler Suspension oder mittels Sublimation.

In einer Ausführungsform des Verfahrens werden eine oder mehrere Schichten mit einem Sublimationsverfahren oder mit einem OVPD (Organic Vapour Phase Deposition) Verfahren oder mit Hilfe einer Trägergassublimation beschichtet oder eine oder mehrere Schichten werden aus Lösung oder mit einem beliebigen Druckverfahren hergestellt.

In einem weiteren Aspekt betrifft die Erfindung ein Verfahren zur Veränderung der Emissions- und/oder Absorptionseigenschaften eines elektronischen Bauelements, wobei ein Kupfer(I)komplex der Formel 1 in ein Matrixmaterial zur Leitung von Elektronen oder Löchern in einem optoelektronischen Bauelement eingebracht wird.

Die Erfindung betrifft in einem weiteren Aspekt die Verwendung eines Kupfer(I)komplexes der Formel 1, insbesondere in einem optoelektronischen Bauelement, zur Umwandlung von UV-Strahlung oder von blauem Licht in sichtbares Licht, insbesondere in grünes, gelbes oder rotes Licht (Down-Konversion).

## Beispiele

Beispiel 1: Allgemeine Arbeitsvorschrift (AAV) 1 - Herstellung von Komplexen

Das entsprechende Kupfersalz (1.00 Äquiv., 1.00 mmol), die Liganden (N,P-Ligand a: 1.50 Äquiv., 1.50 mmol; b: 0.50 Äquiv., 0.50 mmol sowie bei b: Pnictid-Donor (1.00 Äquiv, 1.00 mmol)) werden unter Stickstoff in einem 20 mL Crimp-Vial mit Rührfisch vorgelegt. Die Mischung wird mit 10 mL trockenem Dichlormethan versetzt. Die Reaktion wird gerührt bis eine klare, zumeist gelbe Lösung vorlag. Die Reaktionsmischung wurde über einen Spritzenfilter (0.45 μm) filtriert und in mind. 50-fachem Volumenüberschuss Methanol, Diethylether oder n-Hexan (s. jeweilige Einträge) ausgefällt. Die Produkte wurden abfiltriert und unter vermindertem Druck getrocknet.

Beispiel 2: *(PyrPHOS)(tris-m-tolyl-phosphin)*$_2$*Cu*$_2$*I*$_2$**(11-I-s):**

Der Komplex wurde nach AAV 1 hergestellt und zur Aufreinigung aus n-Hexan ausgefällt und

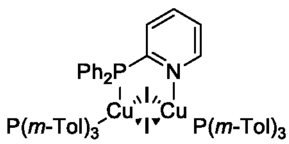

für 24 bei Raumtemperatur (r.t.) am Hochvakuum getrocknet. Ausbeute: 63 %, 662 μmol, 830 mg, hellgelbes Pulver. - $^1$H NMR (500 MHz, Chloroform-*d*) δ = 8.75 (s, 1H), 7.77 - 7.46 (m, 7H), 7.44 - 7.30 (m, 11H), 7.23 (t, *J* = 8.4 Hz, 7H), 7.15 (s, 12H), 2.20 (s, 18H) ppm. - $^{31}$P NMR (250 MHz, Chloroform-d): δ = -12.1 (PyrPHOS), -14.6 ($PR_3$) ppm. - FAB-MS *m/z* (%): 1166 [$Cu_2I_2P_2Y^+$], 1053 [$Cu_3I_2P^+$], 1012 [$Cu_3I_2YP^+$], 970 [$Cu_3I_2Y_2^+$], 861 [$Cu_2IP_2^+$], 820 [$Cu_2IPY^+$], 749 [$Cu_3I_2P^+$], 708 [$Cu_3I_2Y^+$], 671 [$CuP_2^+$], 630 [$CuYP^+$], 589 [$CuY_2^+$], 558 [$Cu_2IP^+$], 516 [$Cu_2IY^+$], 367 [$CuP^+$], 326 [$CuY^+$]. - IR (ATR) 3045 (vw), 2918 (vw), 1590 (vw), 1477 (w), 1451 (w), 1433 (w), 1420 (vw), 1157 (vw), 1105 (m), 1028 (vw), 997 (w), 888 (vw), 774 (s), 743 (s), 694 (vs), 547 (m), 520 (m), 511 (m), 492 (m), 467 (m), 447 (m), 422 (w) cm$^{-1}$. - $C_{59}H_{56}NCu_2I_2P_3$(1251.03): ber. C 56.56, H 4.51, N 1.12; gef. C 56.16, H 4.37, N 0.92.

Beispiel 3: *(MePyrPHOS)(Tris-m-tolyl-phosphin)*$_2$*Cu*$_2$*I*$_2$**(1-I-s)***:*

Der Komplex wurde nach AAV 1 hergestellt und zur Aufreinigung aus n-Hexan ausgefällt und

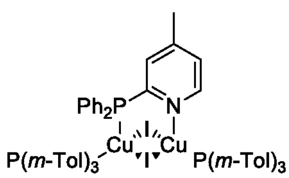

für 24 bei r.t. am Hochvakuum getrocknet. Ausbeute: 59 %, hellgelbes Pulver. - $^1$H NMR (500 MHz, Chloroform-d) δ = 8.78 (s, 1H), 7.80 - 7.48 (m, 7H), 7.40 - 7.30 (m, 10H), 7.22 (t, *J* = 8.3 Hz, 7H), 7.15 (s, 12H), 2.25 (s, 3H), 2.20 (s, 18H) ppm. - $^{31}$P NMR (250 MHz, Chloroform-d): δ = -10.1 (MePyrPHOS), -14.5 ($PR_3$) ppm. - FAB-MS *m/z* (%): 339 [$CuL^+$], 366 [$CuP^+$], 530 [$Cu_2IL^+$], 559 [$Cu_2IP^+$], 644 [$CuPL^+$], 671 [$CuP_2^+$], 722 [$Cu_3I_2L^+$], 748 [$Cu_3I_2P^+$], 862 [$Cu_2IP_2^+$], 1028

$[Cu_3I_2LP^+]$. - IR (ATR) 3044 (vw), 2936 (vw), 2916 (vw), 1591 (vw), 1477 (w), 1451 (w), 1431 (w), 1420 (vw), 1158 (vw), 1106 (m), 1029 (vw), 999 (w), 886 (vw), 772 (s), 741 (s), 691 (vs), 544 (m), 516 (m), 510 (m), 492 (m), 467 (m), 449 (m), 420 (w) $cm^{-1}$. - $C_{60}H_{58}Cu_2I_2NP_3$: ber. C 56.88, H 4.61, N 1.11; gef. C 56.84, H 4.57, N 0.79.

Beispiel 4: *(Tris-(3-methyl-phenyl)phosphin)(4-tBu-pyridin)$Cu_2Br_2$* (**E-Br-s**)

Der Komplex wurde nach AAV 1 als in Acetonitril unlöslicher Komplex hergestellt. Zur

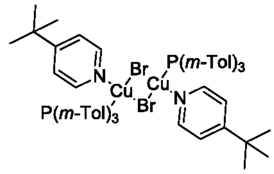

weiteren Aufreinigung wurde die Verbindung in wenig Dichlormethan gelöst und aus 100 ml n-Hexan ausgefällt und für 24 bei r.t. am Hochvakuum getrocknet. Ausbeute: 83%, 210 μmol, 264 mg; weißes Pulver. - $^1$H NMR (500 MHz, Chloroform-d) δ = 8.68 - 8.57 (m, 4H), 7.40 (d, *J* = 11.2 Hz, 6H), 7.36 - 7.22 (m, 10H), 7.20 - 7.12 (m, 12H), 2.20 (s, 18H), 1.40 (s, 18H) ppm. - $^{31}$P NMR (202 MHz, Chloroform-d) δ = -3.5 ppm. - FAB-MS *m/z* (%): 198 $[CuN^+]$, 368 $[CuP^+]$, 502 $[CuNP^+]$, 511 $[Cu_2BrP^+]$, 654 $[Cu_3Br_2P^+]$, 671 $[CuP_2^+]$, 815 $[Cu_2BrP_2^+]$. -IR (ATR) 2960 (w), 1606 (w), 1591 (w), 1496 (w), 1475 (w), 1416 (m), 1368 (w), 1273 (w), 1224 (w), 1171 (w), 1107 (m), 1072 (w), 1015 (w), 997 (w), 891 (w), 844 (m), 827 (m) 779 (s), 721 (w), 694 (vs), 567 (s), 550 (s), 521 (w), 450 (vs), 425 (w) $cm^{-1}$. - $C_{60}H_{68}Br_2Cu_2N_2P_2$ (1162.18): ber. C 61.80, H 5.88, N 2.40; gef. C 61.40, H 5.74, N 2.18.

Beispiel 5: *(Tris-(3-methyl-phenyl)phosphin)(4-tBu-pyridin)$Cu_2I_2$* (**E-I-s**)

Der Komplex wurde nach AAV 1 als in Acetonitril unlöslicher Komplex hergestellt. Zur

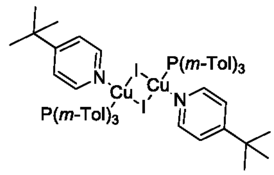

weiteren Aufreinigung wurde die Verbindung in wenig Dichlormethan gelöst und aus 100 ml Methanol ausgefällt und für 24 bei r.t. am Hochvakuum getrocknet. Ausbeute: 94%, 233 μmol, 292 mg; weißes Pulver. - $^1$H NMR (500 MHz, Chloroform-d) δ = 8.66 - 8.60 (m, 4H), 7.41 (d, *J* = 11.0 Hz, 6H), 7.32 - 7.24 (m, 10H), 7.21 - 7.13 (m, 12H), 2.23 (s, 18H), 1.33 (s, 18H) ppm. - $^{31}$P NMR (202 MHz, Chloroform-d) δ = -6.8 ppm. - FAB-MS *m/z* (%): 198 $[CuN^+]$, 368 $[CuP^+]$, 502 $[CuNP^+]$, 558 $[Cu_2IP^+]$, 671 $[CuP_2^+]$, 748 $[Cu_3I_2P^+]$, 863 $[Cu_2IP_2^+]$, 1052 $[Cu_2I_2P_2^+]$. - IR (ATR) 2962 (w), 2920 (w), 2865 (w), 1604 (w), 1591 (w), 1494 (w), 1477 (w), 1449 (m), 1415 (w), 1365 (w), 1272 (w), 1222 (vw), 1172 (s), 1106 (vw), 1069 (vs), 1011 (vw), 995 (vw), 842 (vw), 830 (m), 784 (m), 772 (vs), 720 (vs), 693 (vs), 685 (vs), 569 (s), 547 (s), 514 (w), 464 (m), 446 (vs), 422 (m) $cm^{-1}$. - $C_{60}H_{68}Cu_2I_2N_2P_2$ (1258.15): ber. C 57.19, H 5.44, N 2.20; gef. C 57.10, H 5.30, N 1.93.

Beispiel 6: Kristallstruktur von Komplex **C-Br-s**

Die Kristallstruktur ist in Figur 4 angegeben.

| | |
|---|---|
| $C_{76}H_{66}Br_2Cu_2N_4P_2 \cdot 0.5(C_2H_3N)$ | Z = 2 |
| $M_r$ = 1404,69 | *F*(000) = 1438 |
| Triklin, *P-1 (no.2)* | $D_x$ = 1,466 Mg $m^{-3}$ |
| *a* = 14.064 (2) Å | Mo *K*α Strahlung, λ = 0,71073 Å |
| *b* = 15.730 (2) Å | Cell Parameter aus 238 Reflexen |
| *c* = 17.409 (3) Å | θ = 2,5-25,0° |
| α = 100.75 (1)° | μ = 2,02 $mm^{-1}$ |

(fortgesetzt)

| | |
|---|---|
| $\beta$ = 112.88(1)° | $T$ = 123 K |
| $\gamma$ = 107.31 (1)° | Plättchen, Farblos |
| $V$ = 3181.4 (9) $Å^3$ | 0,30 × 0,12 × 0,08 mm |

| | |
|---|---|
| Bruker-Nonius Diffraktometer | KappaCCD 8330 Reflexe mit $I > 2\sigma(I)$ |
| Strahlenquelle: Feinfokus Röhre | $R_{int}$ = 0,083 |
| Rotation in $\Phi$ und $\omega$, 2° Scans | $\theta_{max}$ = 27,5°, $\theta_{min}$ = 2,6° |
| Absorptionskorrektur: *SADABS* (Sheldrick, 2008) | Multi-Scan $h = -18 \rightarrow 17$ |
| $T_{min}$ = 0,701, $T_{max}$ = 0,862 | $k = -20 \rightarrow 20$ |
| 40213 gemessene Reflexe | $l = -22 \rightarrow 22$ |
| 14539 unabhängige Reflexe | |

| | |
|---|---|
| Verfeinerung von $F^2$ | Schweratommethode |
| $R[F^2 > 2\sigma(F^2)]$ = 0,064 | Wasserstoffe: Anhand der Nachbaratome bestimmt |
| $wR(F^2)$ = 0,128 | H-Atom Parameter wurden festgehalten |
| $S$ = 1,01 | $w = 1/[\sigma^2(F_o^2) + (0{,}0442P)^2 + 1{,}6P]$ where $P = (F_o^2 + 2F_c^2)/3$ |
| 14539 Reflexe | $(\Delta/\sigma)_{max}$ = 0,001 |
| 784 Parameter | $\Delta\rangle_{max}$ = 0,84 e $Å^{-3}$ |
| 257 Festgehaltene | $\Delta\rangle_{min}$ = -0,70 e $Å^{-3}$ |

Die $P(mTol)_3$-Reste sind wie erwartet stark fehlgeordnet.

Beispiel 7: Erhöhung der Stabilität in Lösung

Bei Verwendung von Pyridinen und Phosphinen mit stark unterschiedlicher Löslichkeit treten bevorzugt Zersetzungen auf. Dies zeigte sich beim Versuch der Synthese des Komplexes **EI-a,** bei dem 4-*t*Bu-Pyridin **E** und Triphenylphosphin **a** kombiniert werden sollten. Während die Verwendung von Tris-*m*-tolylphosphin **s** den gewünschten Komplex **E-I-s** ergab, konnte anstelle von **E-I-a** lediglich der unlösliche Phosphincluster $[CuIPPh_3]_n$ isoliert werden.

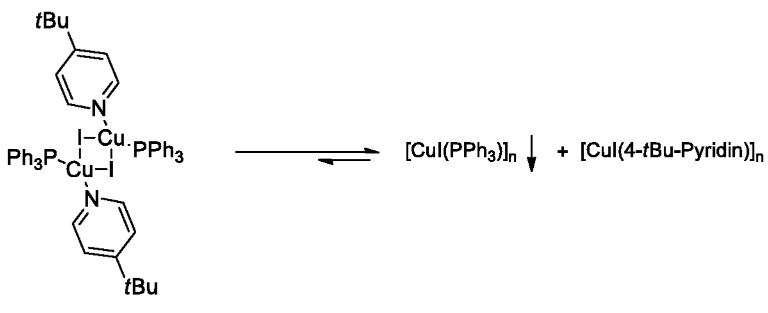

**E-I-a**

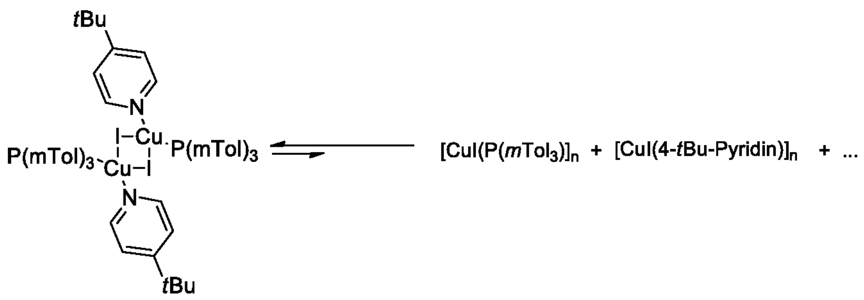

**E-I-s**

Werden in heteroleptischen Komplexen Liganden mit einer stark unterschiedlichen Löslichkeit verwendet, so eröffnet sich durch die auftretenden Gleichgewichte die Möglichkeit zur Bildung von schwerlöslichen Niederschlägen. Im oberen Beispiel verschiebt sich das Gleichgewicht beim Versuch der Synthese des Komplexe **E-I-a** durch die Bildung von $[CuI(PPh_3]_n$ auf die Seite von unerwünschten Nebenprodukten, während im unteren Fall für **E-I-s** die Synthese gelang.

Ein Grund für dieses Verhalten ist neben der erhöhten Löslichkeit auch die oben diskutierte zusätzlich erhöhte Bildungsentropie von E-I-s. Etwaige hochsymmetrische Konkurrenzprodukte wie $[CuI(P(m\mathrm{Tol}_3)]_4$ haben aufgrund der Symmetrie deutlich weniger nicht-entartete Freiheitsgrade und sind daher weniger stark bevorzugt.

Beispiel 8: Erhöhung der Löslichkeit

Allgemein besonders günstig für erhöhte Löslichkeit sind unsymmetrische Liganden wie m-Tolylphosphin **s,** wie sowohl für die Komplexe **1-I-s** und **11-I-s** als auch die Komplexe **C-Brs, E-Br-s** und **E-I-s** gezeigt werden konnte. Bei Koordination an ein Kupferatom könnten die *m*-Tolyl-Gruppen jeweils auf zwei verschiedene Weisen gedreht vorliegen (Figur 5). Vermutlich wird auf dieses Weise die Packung im Festkörper gestört, wodurch eine höhere Löslichkeit erzielt wird. In der Wärme (60 °C) wurde beispielsweise für Komplex **1-I-s** eine Löslichkeit von rund 40 mg $mL^{-1}$ erreicht; weitere Löslichkeitsdaten sind in Tabelle 1 aufgeführt.

Komplex **1-I-s** zeigt neben einer guten Löslichkeit auch eine besonders hohe Quanteneffizienz, sowohl in Pulver (93%) als auch im Dünnfilm (90%). Interessanterweise kommt es bei der Filmpräparation dieser Verbindung zu nahezu keiner Verschiebung der Emissionswellenlänge (Film: 550 nm, Pulver: 547 nm). Offenbar liegt bereits im Festkörper eine Verzerrung ähnlich der Situation im Film vor. Die Struktur wird, wie oben erläutert wurde, durch die als sterisch anspruchsvolle Gruppen wirkenden Tolylreste stabilisiert.

Tabelle 1: Löslichkeitstests für Komplex 1-I-s.

| **Konzentration:** | **2,5 mg/mL** | **5 mg/mL** | **10 mg/mL** |
|---|---|---|---|
| Cyclooctan | Ja | Ja (Wärme) | Nein |
| 1-Hexanol | Ja | Ja (Wärme) | Ja (Wärme) |
| 1-Heptanol | Ja | Ja (Wärme) | Ja (Wärme) |
| Acetonitril | Ja | Ja (Wärme) | Ja (Wärme) |
| Essigester | Ja | Ja | Ja |
| Aceton | Ja | Ja | Ja |
| Tetralin | Ja | Ja | Ja (max. 20 mg/mL) |
| O-Xylol | Ja | Ja | Ja (max. 20 mg/mL) |
| Mesitylen | Ja | Ja | Ja (max. 20 mg/mL) |

Beispiel 9: DFT-Berechnung der Entropie eines erfindungsgemäßen Liganden und Vergleich mit einem Liganden nach dem Stand der Technik

Für die Berechnung der Host-Moleküle wurde Dichtefunktionaltheorie (DFT) unter Verwendung des BP86-Funktionals (Becke, A. D. Phys. Rev. A1988, 38, 3098-3100; Perdew, J. P. Phys. Rev. B1986, 33, 8822-8827) und des def2-SV(P)-Basissatzes (Weigend, F.; Ahlrichs, R. Phys. Chem. Chem. Phys. 2005, 7, 3297-3305; Rappoport, D.; Furche, F. J. Chem. Phys.2010, 133, 134105/1-134105/11) verwendet. Zur numerischen Integration kam das m4-Grid

zum Einsatz und die resolution-of-identity-Näherung (RI) wurde in allen Rechnungen verwendet.(Häser, M.; Ahlrichs, R. J. Comput. Chem. 1989, 10, 104-111; Weigend, F.; Häser, M. Theor. Chem. Acc. 1997, 97, 331-340; Sierka, M.; Hogekamp, A.; Ahlrichs, R. J. Chem. Phys. 2003, 118, 9136-9148) Für jeden Liganden wurde durch eine Berechnung der harmonischen Schwingungsfrequenzen sichergestellt, dass tatsächlich ein Minimum gefunden wurde. Alle DFT-Rechnungen wurden mit dem Turbomole-Programmpaket (Version 6.5) durchgeführt. (TURBOMOLE V6.5 2013, a development of University of Karlsruhe and Forschungszentrum Karlsruhe GmbH, 1989-2007, TURBOMOLE GmbH, since 2007; available at http://www. turbomole.com).

Die temperaturabhängige Entropie wurde für $P(m\text{-}Tol)_3$ (lig2) und $P(p\text{-}Tol)_3$ (lig1) für drei Temperaturen berechnet (298,15K, 314,82K, 331,48K), wobei Werte von 0,721, 0,747, 0,761 kJ/mol/K and 0,711, 0,731, 0,751 kJ/mol/K für lig1 und lig2 erhalten wurden.

Vergleicht man nun den symmetrischen Liganden $P(p\text{-}Tol)_3$ mit dem unsymmetrischen $P(m\text{-}Tol)_3$, so ergeben sich durch die $2^3 = 8$ zusätzlichen Freiheitsgrade der Konformation ein zusätzlicher Entropiebeitrag von $\Delta S = 7{,}1\ J\ mol^{-1}\ K^{-1}$. In der Realität kommen durch zusätzliche Freiheitsgrade der Drehung und Vibration je nach vorliegender Temperatur noch weitere Freiheitsgrade hinzu, sodass dieser Zahlenwert die Untergrenze für die konformative Stabilisierung darstellt.

Herstellung und Charakterisierung von organischen Bauelementen

Es wurden (noch nicht optimierte) OLEDs hergestellt und standardmäßig charakterisiert; hierfür werden die Elektrolumineszenzspektren, die externe Quanteneffizienz (external quantum efficiency, EQE; gemessen in %) in Abhängigkeit von der Helligkeit, berechnet aus Strom-Spannungs-Helligkeit-Kennlinien (IUL-Kennlinien), die Stromdichte, die Leuchtdichte ($L_{max}$), die Leistungseffizienz ($P_{eff}$) und die Stromeffizienz ($C_{eff}$) bestimmt.

Beispiel 10: **(1-I-s)** in einem OLED-Bauteil

| Schicht 1 | Schicht 2 | Schicht 3 | Schicht 4 | Schicht 5 | Schicht 6 | Schicht 7 |
|---|---|---|---|---|---|---|
| Glas oder Plastik | ITO | PEDOT:PSS | **(1-I-s):**PYD2 (40:60) | TPBi | LiF | Al |

Pixelgröße: 24 $mm^2$

$L_{max}$: 5031 $cd/m^2$

$P_{eff}$: 21,954 lm/W

$C_{eff}$: 40,679 cd/A

EQE: 12,5 %

Stromdichte bei 1000 $cd/m^2$: 2,65 $mA/cm^2$

Spannung bei 1000 $cd/m^2$: 6,61 V.

Die Stromdichte und Leuchtdichte über der Spannung sind in Figur 6 dargestellt. Die externe Quanteneffizienz über der Stromdichte ist in Figur 7 dargestellt. Die Leistungseffizienz und Stromeffizienz über der Spannung sind in Figur 8 dargestellt. Die Intensität über die Wellenlänge ist in Figur 9 dargestellt.

**Figuren**

Figur 1: Schematischer Aufbau einer OLED (die Vorrichtung umfasst mindestens eine Anode, eine Kathode und eine Emitterschicht.)

Figur 2: Abhängigkeit der Anzahl möglicher Konformere vom Substitutionsmuster. Durch Verwendung von $P(m\text{-}Tol)_3$ steigt infolge der Möglichkeit der Ausbildung von nicht-äquivalenten Konformeren die Konformationsentropie.

Figur 3: Zusätzliche Freiheitsgrade von $P(m\text{-}Tol)_3$ aufweisenden Komplexen im Vergleich zu den $P(p\text{-}Tol)_3$ Derivaten. Durch Verwendung von $P(m\text{-}Tol)_3$ werden durch den Einbau in Kupferkomplexe zusätzliche Konformationsfreiheitsgrade generiert. Die Zahl der zusätzlichen Freiheitsgrade wird jedoch durch im Komplex vorhandene Symmetrieelemente reduziert.

Figur 4: Kristallstruktur von Komplex C-Br-s.

Figur 5: Konformere Formen des Ligand **s** in einem Kupferkomplex.

Figur 6: Stromdichte und Leuchtdichte über der Spannung für ein OLED-Bauteil mit **1-I-s** als Emitter. Hierbei verdeutlichen die Kreise mit den Pfeilen, an welcher Achse die Daten der jeweiligen Kurve abzulesen sind.

Figur 7: Die externe Quanteneffizienz (EQE) über der Stromdichte für ein OLED-Bauteil mit **1-I-s** als Emitter.

Figur 8: Die Leistungseffizienz und Stromeffizienz über der Spannung für ein OLED-Bauteil mit **1-I-s** als Emitter. Hierbei verdeutlichen die Kreise mit den Pfeilen, an welcher Achse die Daten der jeweiligen Kurve abzulesen sind.

Figur 9: Die Intensität über die Wellenlänge für ein OLED-Bauteil mit **1-I-s** als Emitter (Intensität in willkürlichen Einheiten (a. u.) über Wellenlänge in nm bzw. Energie E in eV).

**Patentansprüche**

**1.** Verwendung eines positiv geladenen oder neutralen ein- oder mehrkernigen Kupfer(I)komplexes aufweisend eine Struktur der Formel 1 in einem optoelektronischen Bauteil

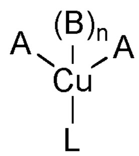

Formel 1

mit L: Ligand nach der Unterformel 1

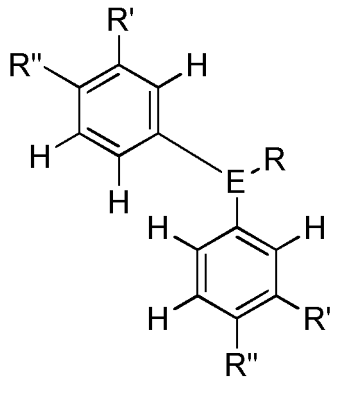

Unterformel 1

mit E: Arsen oder Phosphor;
mit R: R ist bei jedem Auftreten gleich oder verschieden H, D, ein weiterer in meta-Position mit R' und optional in para-Position mit R'' substituierter Phenylring oder Heteroarylring wie Pyridin, eine geradkettige Alkyl-, Alkoxy- oder Thioalkylgruppe mit 1 bis 8 C-Atomen oder eine verzweigte oder cyclische Alkyl-, Alkoxy- oder Thioalkylgruppe mit 3 bis 8 C-Atomen oder eine Alkenyl- oder Alkinylgruppe mit 2 bis 8 C-Atomen, wobei die oben genannten Gruppen jeweils mit einem oder mehreren Resten R" substituiert sein können und wobei eine oder mehrere $CH_2$- Gruppen in den oben genannten Gruppen durch $-R^3C=CR^3-$, -C=C-, $Si(R^3)_2$, C=O, C=S, $C=NR^3$, -C(=O)O-, $-C(=O)NR^3-$, $NR^3$, $P(=O)(R^3)$, -O-, -S-, SO oder $SO_2$ ersetzt sein können und wobei ein oder mehrere H-Atome in den oben genannten Gruppen durch D ersetzt sein können, oder ein aromatisches Ringsystem mit 6 bis 30 aromatischen Ringatomen, das jeweils durch einen oder mehrere Reste R’’’ substituiert sein kann, oder eine Aryloxygruppe mit 6 bis 30 aromatischen Ringatomen, die durch einen oder mehrere Reste R’’’ substituiert sein kann;

mit R’: R’ ist bei jedem Auftreten gleich oder verschieden, Methyl, Ethyl, n-Propyl, i-Propyl, t-Butyl, n-Butyl, i-Butyl, s-Butyl;

mit R": R" ist bei jedem Auftreten gleich oder verschieden H, D, einer geradkettige Alkyl-, Alkoxy- oder Thioalkylgruppe mit 1 bis 8 C-Atomen oder einer verzweigte oder cyclische Alkyl-, Alkoxy- oder Thioalkylgruppe mit 3 bis 8 C-Atomen oder eine Alkenyl- oder Alkinylgruppe mit 2 bis 8 C-Atomen, Phenyl, Pyridyl, Aryl;

mit R’’’: ist bei jedem Auftreten gleich oder verschieden H, Alkyl oder Aryl;

mit $R^3$: ist bei jedem Auftreten gleich oder verschieden H, Alkyl oder Aryl;

mit n = 0 oder 1;

mit A, B: unabhängig voneinander ausgewähltes neutrales oder monoanionisches, koordinierendes Donoratom ausgewählt aus der Gruppe bestehend aus N, P, As, S, O, F, Cl, Br, I, Pseudohalogenid, welches optional Teil eines überbrückenden oder chelatisierenden mehrzähnigen Liganden ist und wobei bei Anwesenheit von B der Kupferkomplex CuLAAB insbesondere tetraedrisch oder pseudotetraedrisch koordiniert ist und bei Abwesenheit von B der resultierende Kupferkomplexe CuLAA insbesondere eine verzerrt trigonal-planare Geometrie aufweist.

2. Verwendung nach Anspruch 1, wobei A und B unabhängig voneinander ausgewählt ein neutrales oder monoanionisches, koordinierendes Donoratom ausgewählt aus der Liste N, P, As, S, O, F, Cl, Br, I, Pseudohalogenid ist, welches optional auch Teil eines überbrückenden oder chelatisierenden mehrzähnigen Liganden ist, und wobei mindestens einer der Liganden A oder B ungleich F, Cl, Br, I, oder Pseudohalogenid ist.

3. Verwendung nach Anspruch 1, wobei L eine Struktur gemäß der Unterformel 2 aufweist

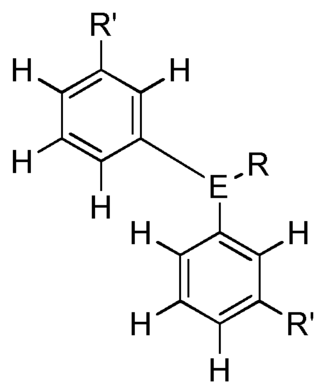

Unterformel 2

wobei R, R’ und E wie in Anspruch 1 definiert sind.

4. Verwendung nach Anspruch 1, wobei L eine Struktur gemäß der Unterformel 4 aufweist

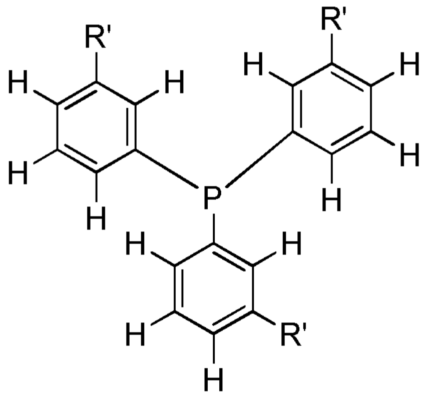

Unterformel 4

wobei R' wie in Anspruch 1 definiert ist.

**5.** Verwendung nach Anspruch 1 bis 4, wobei der Kupfer(I)komplex als Emitter oder Absorber in einem optoelektronischen Bauelement, das durch ein Vakuumverdampfungsverfahren oder aus Lösung hergestellt wird, eingesetzt wird.

**6.** Verwendung nach Anspruch 5, wobei das optoelektronische Bauelement ausgewählt ist aus der Gruppe bestehend aus:

- Organischen Licht-emittierenden Dioden (OLEDs),
- Licht-emittierenden elektrochemischen Zellen,
- OLED-Sensoren, insbesondere in nicht hermetisch nach außen abgeschirmten Gas- und Dampf-Sensoren,
- organischen Solarzellen,
- Organischen Feldeffekttransistoren,
- Organischen Lasern und
- Down-Konversions-Elementen.

**7.** Optoelektronisches Bauelement, aufweisend einen Kupfer(I)komplex der Formel 1

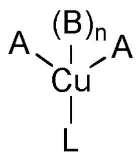

Formel 1

mit L: Ligand nach der Unterformel 1

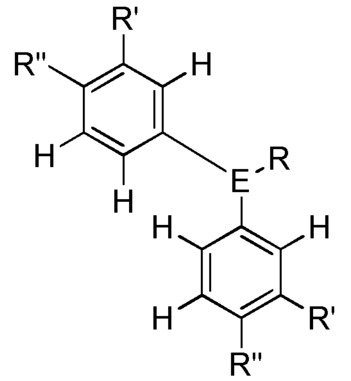

Unterformel 1

mit E: Arsen oder Phosphor

mit R: R ist bei jedem Auftreten gleich oder verschieden H, D, ein weiterer in meta-Position mit R' und optional in para-Position mit R" substituierter Phenylring oder Heteroarylring wie Pyridin eine geradkettige Alkyl-, Alkoxy- oder Thioalkylgruppe mit 1 bis 8 C-Atomen oder eine verzweigte oder cyclische Alkyl-, Alkoxy- oder Thioalkylgruppe mit 3 bis 8 C-Atomen oder eine Alkenyl- oder Alkinylgruppe mit 2 bis 8 C-Atomen, wobei die oben genannten Gruppen jeweils mit einem oder mehreren Resten R" substituiert sein können und wobei eine oder mehrere $CH_2$- Gruppen in den oben genannten Gruppen durch $-R^3C=CR^3-$, -C≡C-, $Si(R^3)_2$, C=O, C=S, $C=NR^3$, -C(=O)O-, $-C(=O)NR^3-$, $NR^3$, $P(=O)(R^3)$, -O-, -S-, SO oder $SO_2$ ersetzt sein können und wobei ein oder mehrere H-Atome in den oben genannten Gruppen durch D ersetzt sein können, oder ein aromatisches Ringsystem mit 6 bis 30 aromatischen Ringatomen, das jeweils durch einen oder mehrere Reste R''' substituiert sein kann, oder eine Aryloxygruppe mit 6 bis 30 aromatischen Ringatomen, die durch einen oder mehrere Reste R''' substituiert sein kann;

mit R': R' ist bei jedem Auftreten gleich oder verschieden, Methyl, Ethyl, n-Propyl, i-Propyl, t-Butyl, n-Butyl, i-Butyl, s-Butyl;

mit R": R" ist bei jedem Auftreten gleich oder verschieden H, D, einer geradkettige Alkyl-, Alkoxy- oder Thioalkylgruppe mit 1 bis 8 C-Atomen oder einer verzweigte oder cyclische Alkyl-, Alkoxy- oder Thioalkylgruppe mit 3 bis 8C-Atomen oder eine Alkenyl- oder Alkinylgruppe mit 2 bis 8 C-Atomen, Phenyl, Pyridyl, Aryl;

mit R''': ist bei jedem Auftreten gleich oder verschieden H, Alkyl oder Aryl;

mit $R^3$: ist bei jedem Auftreten gleich oder verschieden H, Alkyl oder Aryl;

mit n = 0 oder 1;

mit A, B: unabhängig voneinander ausgewähltes neutrales oder monoanionisches, koordinierendes Donoratom ausgewählt aus der Liste N, P, As, S, O, F, Cl, Br, I, Pseudohalogenid, welches optional auch Teil eines überbrückenden oder chelatisierenden mehrzähnigen Liganden sein kann und wobei bei Anwesenheit von B der Kupferkomplex CuLAAB tetraedrisch oder pseudotetraedrisch koordiniert ist und bei Abwesenheit von B der resultierende Kupferkomplexe CuLAA eine verzerrt trigonal-planare Geometrie aufweist.

**8.** Optoelektronisches Bauelement nach Anspruch 8, ausgeformt als ein Bauelement ausgewählt aus der Gruppe bestehend aus organischem lichtemittierendem Bauelement, organischer Diode, organischer Solarzelle, organischem Transistor, organischer lichtemittierender Diode, Licht-emittierender elektrochemischer Zelle, organischem Feldeffekttransistor und organischem Laser.

**9.** Optoelektronisches Bauelement nach Anspruch 7 oder 8, wobei die Verbindung gemäß Formel 1 als Emissionsmaterial in einer Emissionsschicht eingesetzt ist, insbesondere entweder als Reinschicht oder in Kombination mit einem Matrixmaterial.

**10.** Optoelektronisches Bauelement nach Anspruch 7 bis 9, **dadurch gekennzeichnet, dass** der Anteil der Verbindung gemäß Formel 1 als Emissionsmaterial in einer Emissionsschicht, insbesondere in einer OLED, zwischen 5 % bis 80 % beträgt.

**11.** Optoelektronisches Bauelement nach Anspruch 9 oder 10, wobei das Matrixmaterial für die Verbindung der Formel 1 ausgewählt ist aus der Gruppe bestehend aus Ketonen, Phosphinoxiden, Sulfoxiden, Sulfonen, Triarylaminen, Carbazolderivaten, Phenoxazinderivaten, Phenothiazinderivaten, Indolocarbazolderivaten, Azacarbazolen, bipolaren Matrixmaterialien, Silanen, Azaborolen, Boronestern, Triazinderivaten und Zinkkomplexen.

**12.** Optoelektronisches Bauelement nach Anspruch 9 bis 11, aufweisend ein Substrat, eine Anode, eine Kathode und mindestens eine lichtemittierende Schicht, die eine Verbindung gemäß Formel 1 und ein Hostmaterial aufweist, dessen Triplett (T1)- und Singulett (S1)-Energieniveaus energetisch höher liegen als die Triplett (T1)- und Singulett (S1)-Energieniveaus der Verbindung gemäß Formel 1, wobei die Anode und die Kathode auf das Substrat aufgebracht ist, und die lichtemittierende Schicht zwischen Anode und Kathode aufgebracht ist.

**13.** Optoelektronisches Bauelement nach Anspruch 12, weiterhin aufweisend mindestens je eine löcher- und elektroneninjizierende Schicht, und mindestens je eine löcher- und eine elektronentransportierende Schicht, wobei die löcher- und elektroneninjizierende Schicht zwischen Anode und Kathode aufgebracht ist, und die löcher- und die elektronentransportierende Schicht zwischen der löcher- und der elektroneninjizierenden Schicht aufgebracht ist, und die lichtemittierende Schicht zwischen der löcher- und der elektronentransportierenden Schicht aufgebracht ist.

**14.** Lichtemittierendes Material, aufweisend eine Verbindung gemäß Formel 1 und ein Hostmaterial, wobei die Triplett (T1)- und Singulett (S1)-Energieniveaus des Hostmaterials energetisch höher liegen als die Triplett (T1)- und Singulett (S1)-Energieniveaus der Verbindung gemäß Formel 1, und wobei das lichtemittierende Material Fluoreszenz oder thermisch aktivierte verzögerte Fluoreszenz emittiert, und einen deltaE(S1-T1)-Wert zwischen dem untersten angeregten Singulett (S1)- und dem darunter liegenden Triplett (T1)-Zustand von kleiner als 2000 $cm^{-1}$ aufweist

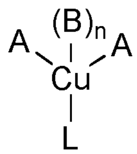

Formel 1

mit L: Ligand nach der Unterformel 1

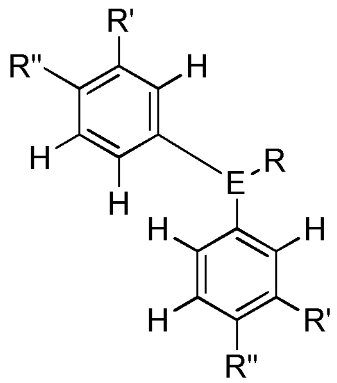

Unterformel 1

mit E: Arsen oder Phosphor

mit R: R ist bei jedem Auftreten gleich oder verschieden H, D, ein weiterer in meta-Position mit R' und optional in para-Position mit R" substituierter Phenylring oder Heteroarylring wie Pyridin eine geradkettige Alkyl-, Alkoxy- oder Thioalkylgruppe mit 1 bis 8 C-Atomen oder eine verzweigte oder cyclische Alkyl-, Alkoxy- oder Thioalkylgruppe mit 3 bis 8 C-Atomen oder eine Alkenyl- oder Alkinylgruppe mit 2 bis 8 C-Atomen, wobei die oben genannten Gruppen jeweils mit einem oder mehreren Resten R" substituiert sein können und wobei eine oder mehrere $CH_2$- Gruppen in den oben genannten Gruppen durch $-R^3C{=}CR^3-$, -C≡C-, $Si(R^3)_2$, C=O, C=S, $C{=}NR^3$, -C(=O)O-, $-C(=O)NR^3-$, $NR^3$, $P(=O)(R^3)$, -O-, -S-, SO oder $SO_2$ ersetzt sein können und wobei ein oder mehrere H-Atome in den oben genannten Gruppen durch D ersetzt sein können, oder ein aromatisches Ringsystem mit 6 bis 30 aromatischen Ringatomen, das jeweils durch einen oder mehrere Reste R''' substituiert sein kann, oder eine Aryloxygruppe mit 6 bis 30 aromatischen Ringatomen, die durch einen oder mehrere Reste R'''

substituiert sein kann;
mit R': R' ist bei jedem Auftreten gleich oder verschieden, Methyl, Ethyl, n-Propyl, i-Propyl, t-Butyl, n-Butyl, i-Butyl, s-Butyl;
mit R": R" ist bei jedem Auftreten gleich oder verschieden H, D, einer geradkettige Alkyl-, Alkoxy- oder Thioalkylgruppe mit 1 bis 8 C-Atomen oder einer verzweigte oder cyclische Alkyl-, Alkoxy- oder Thioalkylgruppe mit 3 bis 8C-Atomen oder eine Alkenyl- oder Alkinylgruppe mit 2 bis 8 C-Atomen, Phenyl, Pyridyl, Aryl;
mit R'": ist bei jedem Auftreten gleich oder verschieden H, Alkyl oder Aryl;
mit $R^3$: ist bei jedem Auftreten gleich oder verschieden H, Alkyl oder Aryl;
mit n = 0 oder 1;
mit A, B: unabhängig voneinander ausgewähltes neutrales oder monoanionisches, koordinierendes Donoratom ausgewählt aus der Liste N, P, As, S, O, F, Cl, Br, I, Pseudohalogenid, welches optional auch Teil eines überbrückenden oder chelatisierenden mehrzähnigen Liganden sein kann und wobei bei Anwesenheit von B der Kupferkomplex CuLAAB tetraedrisch oder pseudotetraedrisch koordiniert ist und bei Abwesenheit von B der resultierende Kupferkomplexe CuLAA eine verzerrt trigonal-planare Geometrie aufweist.

**15.** Verfahren zur Herstellung eines optoelektronischen Bauelements, wobei ein Kupfer(I)komplex der Formel 1 verwendet wird

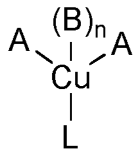

Formel 1

mit L: Ligand nach der Unterformel 1

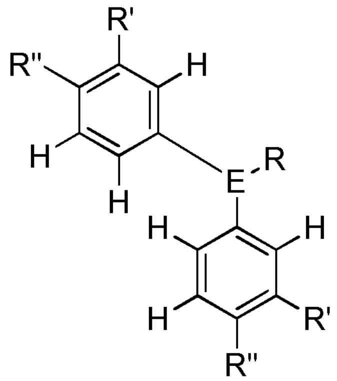

Unterformel 1

mit E: Arsen oder Phosphor
mit R: R ist bei jedem Auftreten gleich oder verschieden H, D, ein weiterer in meta-Position mit R' und optional in para-Position mit R" substituierter Phenylring oder Heteroarylring wie Pyridin eine geradkettige Alkyl-, Alkoxy- oder Thioalkylgruppe mit 1 bis 8 C-Atomen oder eine verzweigte oder cyclische Alkyl-, Alkoxy- oder Thioalkylgruppe mit 3 bis 8 C-Atomen oder eine Alkenyl- oder Alkinylgruppe mit 2 bis 8 C-Atomen, wobei die oben genannten Gruppen jeweils mit einem oder mehreren Resten R" substituiert sein können und wobei eine oder mehrere $CH_2$- Gruppen in den oben genannten Gruppen durch $-R^3C=CR^3-$, -C≡C-, $Si(R^3)_2$, C=O, C=S, $C=NR^3$, -C(=O)O-, $-C(=O)NR^3-$, $NR^3$, $P(=O)(R^3)$, -O-, -S-, SO oder $SO_2$ ersetzt sein können und wobei ein oder mehrere H-Atome in den oben genannten Gruppen durch D ersetzt sein können, oder ein aromatisches Ringsystem mit 6 bis 30 aromatischen Ringatomen, das jeweils durch einen oder mehrere Reste R'" substituiert sein kann, oder eine Aryloxygruppe mit 6 bis 30 aromatischen Ringatomen, die durch einen oder mehrere Reste R"' substituiert sein kann;
mit R': R' ist bei jedem Auftreten gleich oder verschieden, Methyl, Ethyl, n-Propyl, i-Propyl, t-Butyl, n-Butyl, i-Butyl, s-Butyl;

mit R": R" ist bei jedem Auftreten gleich oder verschieden H, D, einer geradkettige Alkyl-, Alkoxy- oder Thioalkylgruppe mit 1 bis 8 C-Atomen oder einer verzweigte oder cyclische Alkyl-, Alkoxy- oder Thioalkylgruppe mit 3 bis 8C-Atomen oder eine Alkenyl- oder Alkinylgruppe mit 2 bis 8 C-Atomen, Phenyl, Pyridyl, Aryl;

mit R’’’: ist bei jedem Auftreten gleich oder verschieden H, Alkyl oder Aryl;

mit $R^3$: ist bei jedem Auftreten gleich oder verschieden H, Alkyl oder Aryl;

mit n = 0 oder 1;

mit A, B: unabhängig voneinander ausgewähltes neutrales oder monoanionisches, koordinierendes Donoratom ausgewählt aus der Liste N, P, As, S, O, F, Cl, Br, I, Pseudohalogenid, welches optional auch Teil eines überbrückenden oder chelatisierenden mehrzähnigen Liganden sein kann und wobei bei Anwesenheit von B der Kupferkomplex CuLAAB tetraedrisch oder pseudotetraedrisch koordiniert ist und bei Abwesenheit von B der resultierende Kupferkomplexe CuLAA eine verzerrt trigonal-planare Geometrie aufweist.

**16.** Verwendung eines Kupfer(I)komplexes der Formel 1, insbesondere in einem optoelektronischen Bauelement, zur Umwandlung von UV-Strahlung oder von blauem Licht in sichtbares Licht, insbesondere in grünes, gelbes oder rotes Licht (Down-Konversion)

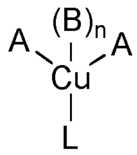

Formel 1

mit L: Ligand nach der Unterformel 1

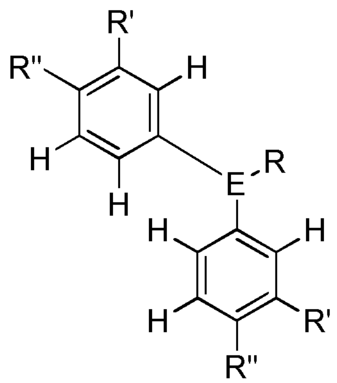

Unterformel 1

mit E: Arsen oder Phosphor;

mit R: R ist bei jedem Auftreten gleich oder verschieden H, D, ein weiterer in meta-Position mit R’ und optional in para-Position mit R" substituierter Phenylring oder Heteroarylring wie Pyridin eine geradkettige Alkyl-, Alkoxy- oder Thioalkylgruppe mit 1 bis 8 C-Atomen oder eine verzweigte oder cyclische Alkyl-, Alkoxy- oder Thioalkylgruppe mit 3 bis 8 C-Atomen oder eine Alkenyl- oder Alkinylgruppe mit 2 bis 8 C-Atomen, wobei die oben genannten Gruppen jeweils mit einem oder mehreren Resten R" substituiert sein können und wobei eine oder mehrere $CH_2$- Gruppen in den oben genannten Gruppen durch $-R^3C=CR^3-$, $-C{\equiv}C-$, $Si(R^3)_2$, C=O, C=S, $C=NR^3$, -C(=O)O-, $-C(=O)NR^3-$, $NR^3$, $P(=O)(R^3)$, -O-, -S-, SO oder $SO_2$ ersetzt sein können und wobei ein oder mehrere H-Atome in den oben genannten Gruppen durch D ersetzt sein können, oder ein aromatisches Ringsystem mit 6 bis 30 aromatischen Ringatomen, das jeweils durch einen oder mehrere Reste R’’’ substituiert sein kann, oder eine Aryloxygruppe mit 6 bis 30 aromatischen Ringatomen, die durch einen oder mehrere Reste R’’’ substituiert sein kann;

mit R’: R’ ist bei jedem Auftreten gleich oder verschieden, Methyl, Ethyl, n-Propyl, i-Propyl, t-Butyl, n-Butyl, i-Butyl, s-Butyl;

mit R": R" ist bei jedem Auftreten gleich oder verschieden H, D, einer geradkettige Alkyl-, Alkoxy- oder Thioalkylgruppe mit 1 bis 8 C-Atomen oder einer verzweigte oder cyclische Alkyl-, Alkoxy- oder Thioalkylgruppe mit 3 bis 8C-Atomen oder eine Alkenyl- oder Alkinylgruppe mit 2 bis 8 C-Atomen, Phenyl, Pyridyl, Aryl;
mit R'": ist bei jedem Auftreten gleich oder verschieden H, Alkyl oder Aryl;
mit $R^3$: ist bei jedem Auftreten gleich oder verschieden H, Alkyl oder Aryl;
mit n = 0 oder 1;
mit A, B: unabhängig voneinander ausgewähltes neutrales oder monoanionisches, koordinierendes Donoratom ausgewählt aus der Liste N, P, As, S, O, F, Cl, Br, I, Pseudohalogenid, welches optional auch Teil eines überbrückenden oder chelatisierenden mehrzähnigen Liganden sein kann und wobei bei Anwesenheit von B der Kupferkomplex CuLAAB tetraedrisch oder pseudotetraedrisch koordiniert ist und bei Abwesenheit von B der resultierende Kupferkomplexe CuLAA insbesondere eine verzerrt trigonal-planare Geometrie aufweist.

## Claims

1. Use of a positively charged or neutral mono- or multinuclear copper(I)complex comprising a structure of formula 1 in an optoelectronic device

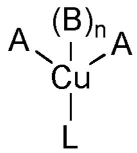

Formula 1

with L: ligand according to sub-formula 1

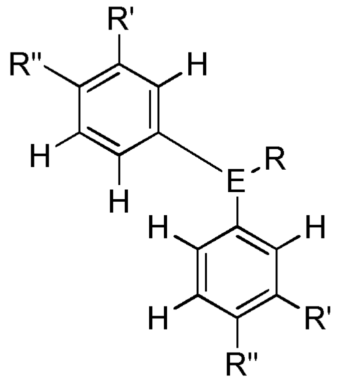

Sub-Formula 1

with E: arsenic or phosphorus;
with R: R is at each occurrence identical or different and is H, D, an additional phenyl ring or heteroaryl ring substituted in meta-position by R' and optionally in para-position by R", such as pyridine, a linear alkyl, alkoxy or thioalkyl group having 1 to 8 C-atoms or a branched or cyclic alkyl, alkoxy or thioalkyl group having 3 to 8 C-atoms or an alkenyl or alkynyl group having 2 to 8 C-atoms, wherein the aforementioned groups in each case can be substituted by one or more moieties R" and wherein one or more $CH_2$-groups of the aforementioned groups can be replaced by $R^3C=CR^3$-, -C≡C-, $Si(R^3)_2$, C=O, C=S, $C=NR^3$, -C(=O)O-, - $C(=O)NR^3$-, $NR^3$, $P(=O)(R^3)$, -O-, -S-, SO or $SO_2$ and wherein one or more H-atoms inside the aforementioned groups can be replaced by D, or an aromatic ring system having 6 to 30 aromatic ring atoms, which can be substituted by one or more moieties R"', or an aryloxy group having 6 to 30 aromatic ring atoms, which can be substituted by one or more moieties R"';
with R': R' is identical or different at each occurrence and is methyl, ethyl, n-propyl, i-propyl, t-butyl, n-butyl, i-butyl, s-butyl;

with R'': R'' is identical or different at each occurrence and is H, D, a linear alkyl, alkoxy or thioalkyl group having 1 to 8 C-atoms or a branched or cyclic alkyl, alkoxy or thioalkyl group having 3 to 8 C-atoms or an alkenyl or alkynyl group having 2 to 8 C-atoms, phenyl, pyridyl, aryl;
with R''': is identical or different at each occurrence and is H, alkyl or aryl;
with $R^3$: is identical or different at each occurrence and is H, alkyl or aryl;
with n = 0 or 1;
with A, B: is a neutral or monoanionic, coordinating donor atom selected from each other the group consistent of N, P, As, S, O, F, Cl, Br, I, pseudo halogenide, which is optionally part of a bridging or chelating polydentate ligand and wherein in presence of B the copper complex CuLAAB is coordinated in particular tetrahedrally or pseudo tetrahedrally and in absence of B the resulting copper complex CuLAA comprises in particular a distorted trigonal planar geometry.

**2.** Use according to claim 1, wherein A and B is independently from each other selected and is a neutral or monoanionic, coordinating donor atom selected from the group N, P, As, S, O, F, Cl, Br, I, pseudo halogenide, which is optionally also part of a bridging or chelating polydentate ligand, and wherein at least one of the ligands A or B are not F, Cl, Br, I, or pseudo halogenide.

**3.** Use according to claim 1, wherein L comprises a structure according to sub-formula 2

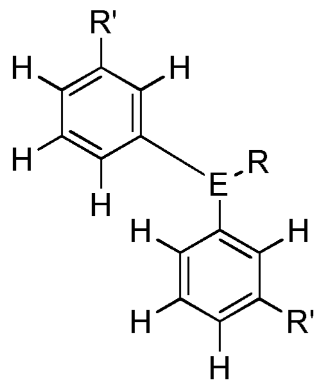

Sub-Formula 2

wherein R, R' and E are defined as in claim 1.

**4.** Use according to claim 1, wherein L comprises a structure according to sub-formula 4

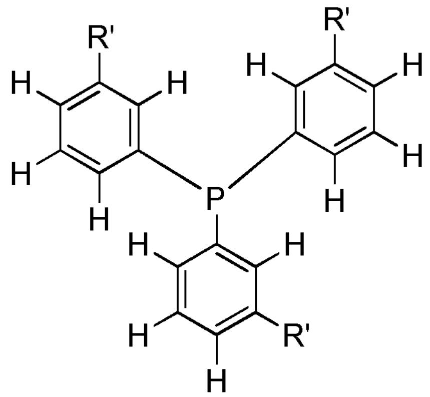

Sub-Formula 4

wherein R' is defined as in claim 1

**5.** Use according to claim 1 to 4, wherein the copper(I)complex is used as an emitter or an absorber in an optoelectronic

device, which is manufactured by a vacuum evaporation procedure or from a solution.

**6.** Use according to Claim 5, wherein the optoelectronic device is selected from the group consisting of:

- organic light-emitting diodes (OLEDs),
- light-emitting electrochemical cells,
- OLED-sensors, in particular in non-hermetically shielded gas and vapor sensors,
- organic solar cells,
- organic field-effect transistors,
- organic lasers, and
- down-conversion elements.

**7.** Optoelectronic device, comprising a copper(I)complex of formula 1

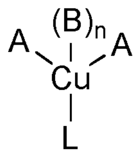

Formula 1

with L: ligand according to sub-formula 1

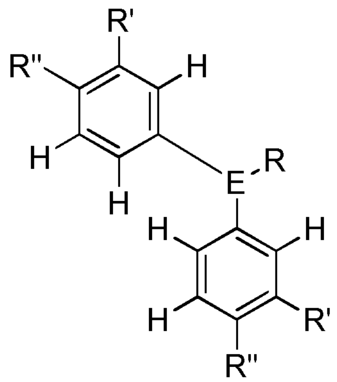

Sub-Formula 1

with E: arsenic or phosphorus;

with R: R is at each occurrence identical or different and is H, D, an additional phenyl ring or heteroaryl ring substituted in meta-position by R' and optionally in para-position by R", such as pyridine, a linear alkyl, alkoxy or thioalkyl group having 1 to 8 C-atoms or a branched or cyclic alkyl, alkoxy or thioalkyl group having 3 to 8 C-atoms or an alkenyl or alkynyl group having 2 to 8 C-atoms, wherein the aforementioned groups in each case can be substituted by one or more moieties R" and wherein one or more $CH_2$-groups of the aforementioned groups can be replaced by $R^3C=CR^3$-, -C≡C-, $Si(R^3)_2$, C=O, C=S, $C=NR^3$, -C(=O)O-, - $C(=O)NR^3$-, $NR^3$, $P(=O)(R^3)$, -O-, -S-, SO or $SO_2$ and wherein one or more H-atoms inside the aforementioned groups can be replaced by D, or an aromatic ring system having 6 to 30 aromatic ring atoms, which can be substituted by one or more moieties R''', or an aryloxy group having 6 to 30 aromatic ring atoms, which can be substituted by one or more moieties R''';

with R': R' is identical or different at each occurrence and is methyl, ethyl, n-propyl, i-propyl, t-butyl, n-butyl, i-butyl, s-butyl;

with R": R" is identical or different at each occurrence and is H, D, a linear alkyl, alkoxy or thioalkyl group having 1 to 8 C-atoms or a branched or cyclic alkyl, alkoxy or thioalkyl group having 3 to 8 C-atoms or an alkenyl or alkynyl group having 2 to 8 C-atoms, phenyl, pyridyl, aryl;

with R''': is identical or different at each occurrence and is H, alkyl or aryl;

with $R^3$: is identical or different at each occurrence and is H, alkyl or aryl;
with n = 0 or 1;
with A, B: is selected independently from each other and is a neutral or monoanionic, coordinating donor atom selected from the group consistent of N, P, As, S, O, F, Cl, Br, I, pseudo halogenide, which is optionally part of a bridging or chelating polydentate ligand and wherein in presence of B the copper complex CuLAAB is coordinated tetrahedrally or pseudo tetrahedrally and in absence of B the resulting copper complex CuLAA comprises a distorted trigonal planar geometry.

**8.** Optoelectronic device according to claim 7, in the form of a device selected from the group consisting of organic light-emitting device, organic diode, organic solar cell, organic transistor, organic light-emitting diode, light-emitting electrochemical cell, organic field-effect transistor and organic laser.

**9.** Optoelectronic device according to claim 7 or 8, wherein a compound according to formula 1 is used as emission material in an emissions layer, in particular either as a pure layer or in combination with a matrix material.

**10.** Optoelectronic device according to claim 7 to 9, **characterized in that** the proportion of the compound according to formula 1 as emission material in an emission layer, in particular in an OLED, is in the range of 5 % to 80 %

**11.** Optoelectronic device according to claim 9 or 10, wherein the matrix material for the compound of the formula 1 is selected form the group consisting of ketones, phosphine oxides, sulfoxides, sulfones, triarylamines, carbazole derivates, phenoxazine derivates, phenothiazine derivates, indolocarbazole derivates, azacarbazoles, bipolar matrix materials, silanes, azaboroles, boronic esters, triazine derivates and zinc complexes.

**12.** Optoelectronic device according to claim 9 to 11, comprising a substrate, an anode, a cathode, and at least one light-emitting layer, which comprises a compound according to formula 1 and a host material with triplet (T1)- and singlet (S1)-energy levels that are energetically higher than the triplet (T1)- and singlet (S1)- energy levels of the compound according to formula 1, wherein the anode and the cathode is deposited on the substrate, and the light emitting layer is deposited between anode and cathode.

**13.** Optoelectronic device according to claim 12, further comprising at least one hole injection layer and one electron injection layer and at least one hole transporting layer and one electron transporting layer, wherein the hole injection layer and the electron injection layer are deposited between anode and cathode, and the hole transporting layer and the electron transporting layer are deposited between the hole injection layer and the electron injection layer and the light emitting layer is deposited between the hole transporting layer and the electron transporting layer.

**14.** Light emitting material, comprising a compound according to formula 1 and a host material, wherein the triplet (T1)- and singlet (S1) energy levels of the host material are energetically higher than the triplet (T1) and singlet (S1) energy levels of the compound according to formula 1, and wherein the light-emitting material emits fluorescence or thermally activated delayed fluorescence, and exhibits a deltaE(S1-T1)-value between the lowest excited singlet state (S1) and the triplet state (T1) below it of less than 2000 $cm^{-1}$.

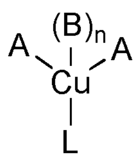

Formula 1

with L: ligand according to sub-formula 1

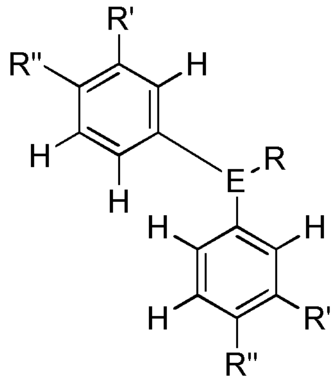

Sub-Formula 1

with E: arsenic or phosphorus;

with R: R is at each occurrence identical or different and is H, D, an additional phenyl ring or heteroaryl ring substituted in meta-position by R' and optionally in para-position by R", such as pyridine, a linear alkyl, alkoxy or thioalkyl group having 1 to 8 C-atoms or a branched or cyclic alkyl, alkoxy or thioalkyl group having 3 to 8 C-atoms or an alkenyl or alkynyl group having 2 to 8 C-atoms, wherein the aforementioned groups in each case can be substituted by one or more moieties R" and wherein one or more $CH_2$-groups of the aforementioned groups can be replaced by $R^3C=CR^3$-, -C≡C-, $Si(R^3)_2$, C=O, C=S, $C=NR^3$, -C(=O)O-, - $C(=O)NR^3$-, $NR^3$, $P(=O)(R^3)$, -O-, -S-, SO or $SO_2$ and wherein one or more H-atoms inside the aforementioned groups can be replaced by D, or an aromatic ring system having 6 to 30 aromatic ring atoms, which can be substituted by one or more moieties R''', or an aryloxy group having 6 to 30 aromatic ring atoms, which can be substituted by one or more moieties R''';

with R': R' is identical or different at each occurrence and is methyl, ethyl, n-propyl, i-propyl, t-butyl, n-butyl, i-butyl, s-butyl;

with R": R" is identical or different at each occurrence and is H, D, a linear alkyl, alkoxy or thioalkyl group having 1 to 8 C-atoms or a branched or cyclic alkyl, alkoxy or thioalkyl group having 3 to 8 C-atoms or an alkenyl or alkynyl group having 2 to 8 C-atoms, phenyl, pyridyl, aryl;

with R''': is identical or different at each occurrence and is H, alkyl or aryl;

with $R^3$: is identical or different at each occurrence and is H, alkyl or aryl;

with n = 0 or 1;

with A, B: is a neutral or monoanionic, coordinating donor atom selected from each other the group consistent of N, P, As, S, O, F, Cl, Br, I, pseudo halogenide, which is optionally part of a bridging or chelating polydentate ligand and wherein in presence of B the copper complex CuLAAB is coordinated in particular tetrahedrally or pseudo tetrahedrally and in absence of B the resulting copper complex CuLAA comprises in particular a distorted trigonal planar geometry.

**15.** Process for producing an optoelectronic device, wherein a copper(I)complex of formula 1 is used

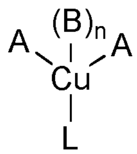

Formula 1

with L: ligand according to sub-formula 1

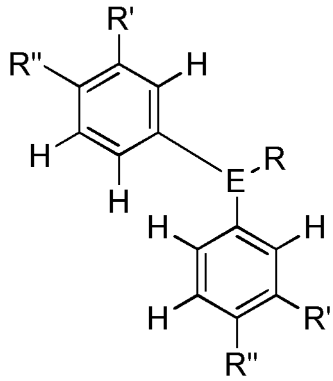

Sub-Formula 1

with E: arsenic or phosphorus;

with R: R is at each occurrence identical or different and is H, D, an additional phenyl ring or heteroaryl ring substituted in meta-position by R' and optionally in para-position by R", such as pyridine, a linear alkyl, alkoxy or thioalkyl group having 1 to 8 C-atoms or a branched or cyclic alkyl, alkoxy or thioalkyl group having 3 to 8 C-atoms or an alkenyl or alkynyl group having 2 to 8 C-atoms, wherein the aforementioned groups in each case can be substituted by one or more moieties R" and wherein one or more $CH_2$-groups of the aforementioned groups can be replaced by $R^3C{=}CR^3$-, -C≡C-, $Si(R^3)_2$, C=O, C=S, $C{=}NR^3$, -C(=O)O-, - $C(=O)NR^3$-, $NR^3$, $P(=O)(R^3)$, -O-, -S-, SO or $SO_2$ and wherein one or more H-atoms inside the aforementioned groups can be replaced by D, or an aromatic ring system having 6 to 30 aromatic ring atoms, which can be substituted by one or more moieties R''', or an aryloxy group having 6 to 30 aromatic ring atoms, which can be substituted by one or more moieties R''';

with R': R' is identical or different at each occurrence and is methyl, ethyl, n-propyl, i-propyl, t-butyl, n-butyl, i-butyl, s-butyl;

with R": R" is identical or different at each occurrence and is H, D, a linear alkyl-, alkoxy- or thioalkyl group having 1 to 8 C-atoms or a branched or cyclic alkyl-, alkoxy- or thioalkyl group having 3 to 8 C-atoms or an alkenyl or alkynyl group having 2 to 8 C-atoms, phenyl, pyridyl, aryl;

with R''': is identical or different at each occurrence and is H, alkyl or aryl;

with $R^3$: is identical or different at each occurrence and is H, alkyl or aryl;

with n = 0 or 1;

with A, B: is selected independently from each other and is a neutral or monoanionic, coordinating donor atom selected from the group consistent of N, P, As, S, O, F, Cl, Br, I, pseudo halogenide, which is optionally part of a bridging or chelating polydentate ligand and wherein in presence of B the copper complex CuLAAB is coordinated tetrahedrally or pseudo tetrahedrally and in absence of B the resulting copper complex CuLAA comprises a distorted trigonal planar geometry.

**16.** Use of a copper(I)complex of formula 1, in particular in an optoelectronic device, for conversion of UV-radiation or of blue light into visible light, in particular into green, yellow or red light (down-conversion)

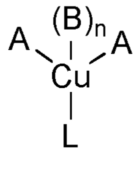

Formula 1

with L: ligand according to sub-formula 1

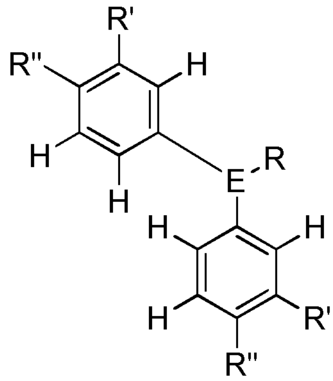

Sub-Formula 1

with E: arsenic or phosphorus;
with R: R is at each occurrence identical or different and is H, D, an additional phenyl ring or heteroaryl ring substituted in meta-position by R' and optionally in para-position by R", such as pyridine, a linear alkyl, alkoxy or thioalkyl group having 1 to 8 C-atoms or a branched or cyclic alkyl, alkoxy or thioalkyl group having 3 to 8 C-atoms or an alkenyl or alkynyl group having 2 to 8 C-atoms, wherein the aforementioned groups in each case can be substituted by one or more moieties R" and wherein one or more $CH_2$-groups of the aforementioned groups can be replaced by $R^3C=CR^3$-, -C≡C-, $Si(R^3)_2$, C=O, C=S, $C=NR^3$, -C(=O)O-, - $C(=O)NR^3$-, $NR^3$, $P(=O)(R^3)$, -O-, -S-, SO or $SO_2$ and wherein one or more H-atoms inside the aforementioned groups can be replaced by D, or an aromatic ring system having 6 to 30 aromatic ring atoms, which can be substituted by one or more moieties R"', or an aryloxy group having 6 to 30 aromatic ring atoms, which can be substituted by one or more moieties R"';
with R': R' is identical or different at each occurrence and is methyl, ethyl, n-propyl, i-propyl, t-butyl, n-butyl, i-butyl, s-butyl;
with R": R" is identical or different at each occurrence and is H, D, a linear alkyl, alkoxy or thioalkyl group having 1 to 8 C-atoms or a branched or cyclic alkyl, alkoxy or thioalkyl group having 3 to 8 C-atoms or an alkenyl or alkynyl group having 2 to 8 C-atoms, phenyl, pyridyl, aryl;
with R"': is identical or different at each occurrence and is H, alkyl or aryl;
with $R^3$: is identical or different at each occurrence and is H, alkyl or aryl;
with n = 0 or 1;
with A, B: is a neutral or monoanionic, coordinating donor atom selected from each other the group consistent of N, P, As, S, O, F, Cl, Br, I, pseudo halogenide, which is optionally part of a bridging or chelating polydentate ligand and wherein in presence of B the copper complex CuLAAB is coordinated in particular tetrahedrally or pseudo tetrahedrally and in absence of B the resulting copper complex CuLAA comprises in particular a distorted trigonal planar geometry.

## Revendications

**1.** Utilisation d'un complexe de cuivre (I) chargé positivement ou neutre, à un ou plusieurs noyaux, présentant une structure de formule 1 dans un composant optoélectronique

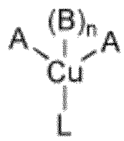

Formule 1

avec L : ligand selon la sous-formule 1

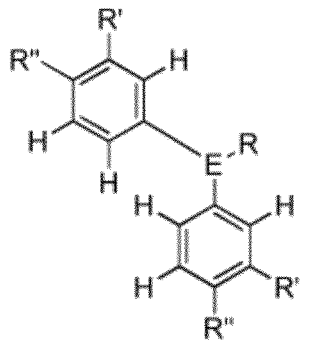

Sous-formule 1

avec E : arsenic ou phosphore ;

avec R : R représente, en chaque occurrence, de manière identique ou différente, H, D, un autre cycle phényle ou hétéroaryle substitué en position méta par R' et éventuellement substitué en position para par R", tel que la pyridine, un groupe alkyle, alcoxy ou thioalkyle linéaire, comprenant 1 à 8 atomes de carbone, ou un groupe alkyle, alcoxy ou thioalkyle ramifié ou cyclique comprenant 3 à 8 atomes de carbone, ou un groupe alcényle ou alcynyle comprenant 2 à 8 atomes de carbone, les groupes susmentionnés pouvant à chaque fois être substitués par un ou plusieurs radicaux R" et un ou plusieurs groupes $CH_2$ dans les groupes susmentionnés pouvant être remplacés par $-R^3C=CR^3-$, -C≡C-, $Si(R^3)_2$, C=O, C=S, $C=NR^3$, -C(=O)O-, $-C(=O)NR^3-$, $NR^3$, $P(=O)(R^3)$, -O-, -S-, SO ou $SO_2$ et un ou plusieurs atomes de H dans les groupes susmentionnés pouvant être remplacés par D, ou un système cyclique aromatique comprenant 6 à 30 atomes de cycle aromatique, qui peut à chaque fois être substitué par un ou plusieurs radicaux R'", ou un groupe aryloxy comprenant 6 à 30 atomes de cycle aromatique qui peut être substitué par un ou plusieurs radicaux R'" ;

avec R' : R' représente, en chaque occurrence, de manière identique ou différente, méthyle, éthyle, n-propyle, i-propyle, t-butyle, n-butyle, i-butyle, s-butyle ;

avec R" : R" représente en chaque occurrence, de manière identique ou différente, H, D, un groupe alkyle, alcoxy ou thioalkyle linéaire comprenant 1 à 8 atomes de carbone ou un groupe alkyle, alcoxy ou thioalkyle ramifié ou cyclique comprenant 3 à 8 atomes de carbone ou un groupe alcényle ou alcynyle comprenant 2 à 8 atomes de carbone, phényle, pyridyle, aryle ; avec R'" : représente en chaque occurrence, de manière identique ou différente, H, alkyle ou aryle ;

avec $R^3$ : représente en chaque occurrence, de manière identique ou différente, H, alkyle ou aryle ;

avec n = 0 ou 1 ;

avec A, B : un atome donneur sélectionné indépendamment l'un de l'autre, neutre ou mono-anionique, coordinant, choisi dans le groupe constitué par N, P, As, S, O, F, Cl, Br, I, pseudohalogénure, qui fait éventuellement partie d'un ligand formant un pont ou polydentate chélatant et, en présence de B, le complexe de cuivre CuLAAB étant en particulier coordiné de manière tétraédrique ou pseudotétraédrique et, en l'absence de B, le complexe de cuivre résultant CuLAA présentant en particulier une géométrie trigonale planaire déformée.

**2.** Utilisation selon la revendication 1, A et B, choisis indépendamment l'un de l'autre, représentant un atome donneur, neutre ou mono-anionique, coordinant, choisi dans la liste N, P, As, S, O, F, Cl, Br, I, pseudohalogénure, qui fait éventuellement aussi partie d'un ligand formant un pont ou polydentate chélatant et au moins un des ligands A et B étant différent de F, Cl, Br, I ou pseudohalogénure.

**3.** Utilisation selon la revendication 1, L présentant une structure selon la sous-formule 2

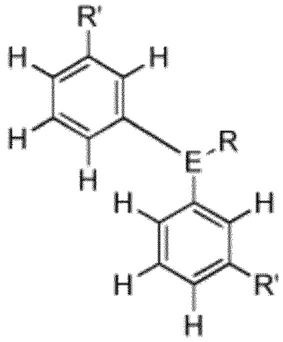

Sous-formule 2

R, R’ et E étant tels que définis dans la revendication 1.

**4.** Utilisation selon la revendication 1, L présentant une structure selon la sous-formule 4

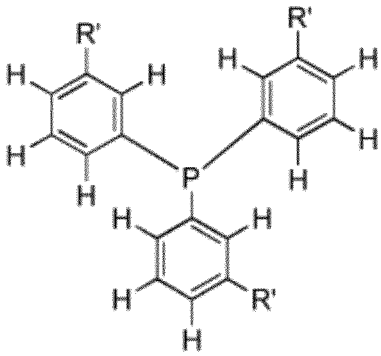

Sous-formule 4

R’ étant tel que défini dans la revendication 1.

**5.** Utilisation selon les revendications 1 à 4, le complexe de cuivre (I) étant utilisé comme émetteur ou absorbant dans un composant optoélectronique, qui a été fabriqué par un procédé d’évaporation sous vide ou à partir d’une solution.

**6.** Utilisation selon la revendication 5, le composant optoélectronique étant choisi dans le groupe constitué par :

- les diodes électroluminescentes organiques (DELO),
- les piles électrochimiques électroluminescentes,
- les capteurs à DELO, en particulier dans les capteurs de gaz et de vapeur, non hermétiquement fermés par rapport à l’extérieur,
- les piles solaires organiques,
- les transistors organiques à effet de champ,
- les lasers organiques et
- les éléments de conversion vers le bas.

**7.** Composant optoélectronique, présentant un complexe de cuivre (I) de formule 1

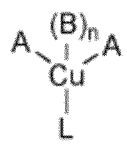

Formule 1

avec L : ligand selon la sous-formule 1

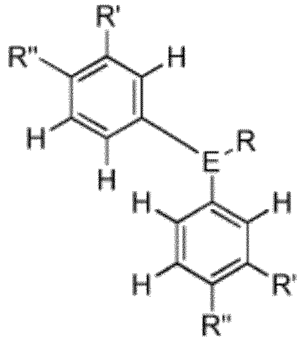

Sous-formule 1

avec E : arsenic ou phosphore

avec R : R représente, en chaque occurrence, de manière identique ou différente, H, D, un autre cycle phényle ou hétéroaryle substitué en position méta par R' et éventuellement substitué en position para par R", tel que la pyridine, un groupe alkyle, alcoxy ou thioalkyle linéaire, comprenant 1 à 8 atomes de carbone, ou un groupe alkyle, alcoxy ou thioalkyle ramifié ou cyclique comprenant 3 à 8 atomes de carbone, ou un groupe alcényle ou alcynyle comprenant 2 à 8 atomes de carbone, les groupes susmentionnés pouvant à chaque fois être substitués par un ou plusieurs radicaux R" et un ou plusieurs groupes $CH_2$ dans les groupes susmentionnés pouvant être remplacés par $-R^3C=CR^3-$, -C≡C-, $Si(R^3)_2$, C=O, C=S, $C=NR^3$, -C(=O)O-, $-C(=O)NR^3-$, $NR^3$, $P(=O)(R^3)$, -O-, -S-, SO ou $SO_2$ et un ou plusieurs atomes de H dans les groupes susmentionnés pouvant être remplacés par D, ou un système cyclique aromatique comprenant 6 à 30 atomes de cycle aromatique, qui peut à chaque fois être substitué par un ou plusieurs radicaux R''', ou un groupe aryloxy comprenant 6 à 30 atomes de cycle aromatique qui peut être substitué par un ou plusieurs radicaux R''' ;

avec R' : R' représente, en chaque occurrence, de manière identique ou différente, méthyle, éthyle, n-propyle, i-propyle, t-butyle, n-butyle, i-butyle, s-butyle ;

avec R" : R" représente en chaque occurrence, de manière identique ou différente, H, D, un groupe alkyle, alcoxy ou thioalkyle linéaire comprenant 1 à 8 atomes de carbone ou un groupe alkyle, alcoxy ou thioalkyle ramifié ou cyclique comprenant 3 à 8 atomes de carbone ou un groupe alcényle ou alcynyle comprenant 2 à 8 atomes de carbone, phényle, pyridyle, aryle ; avec R''' : représente en chaque occurrence, de manière identique ou différente, H, alkyle ou aryle ;

avec $R^3$ : représente en chaque occurrence, de manière identique ou différente, H, alkyle ou aryle ;

avec n = 0 ou 1 ;

avec A, B : un atome donneur sélectionné indépendamment l'un de l'autre, neutre ou mono-anionique, coordinant, choisi dans la liste N, P, As, S, O, F, Cl, Br, I, pseudohalogénure, qui peut éventuellement également faire partie d'un ligand formant un pont ou polydentate chélatant et, en présence de B, le complexe de cuivre CuLAAB étant coordiné de manière tétraédrique ou pseudotétraédrique et, en l'absence de B, le complexe de cuivre résultant CuLAA présentant une géométrie trigonale planaire déformée.

**8.** Composant optoélectronique selon la revendication 7, formé sous forme de composant choisi dans le groupe constitué par un composant électroluminescent organique, les diodes organiques, les piles solaires organiques, les transistors organiques, les diodes électroluminescentes organiques, les piles électrochimiques électroluminescentes, les transistors organiques à effet de champ et les lasers organiques.

**9.** Composant optoélectronique selon la revendication 7 ou 8, le composé selon la formule 1 étant utilisé en tant que

matériau d'émission dans une couche d'émission, en particulier, soit sous forme de couche pure, soit en combinaison avec un matériau de matrice.

**10.** Composant optoélectronique selon la revendication 7 à 9, **caractérisé en ce que** la proportion de composé selon la formule 1 en tant que matériau d'émission dans une couche d'émission, en particulier dans une DELO, est située entre 5% et 80%.

**11.** Composant optoélectronique selon la revendication 9 ou 10, le matériau de matrice pour le composé de formule 1 étant choisi dans le groupe constitué par les cétones, les oxydes de phosphine, les sulfoxydes, les sulfones, les triarylamines, les dérivés de carbazole, les dérivés de phénoxazine, les dérivés de phénothiazine, les dérivés d'indolocarbazole, les azacarbazoles, les matériaux de matrice dipolaires, les silanes, les azaborols, les esters boroniques, les dérivés de triazine et les complexes de zinc.

**12.** Composant optoélectronique selon les revendications 9 à 11, présentant un substrat, une anode, une cathode et au moins une couche électroluminescente, qui présente un composé selon la formule 1 et un matériau hôte dont les niveaux d'énergie de triplet (T1) et de singulet (S1) se situent, d'un point de vue énergétique, au-dessus des niveaux d'énergie de triplet (T1) et de singulet (S1) du composé selon la formule 1, l'anode et la cathode étant appliquées sur le substrat et la couche électroluminescente étant appliquée entre l'anode et la cathode.

**13.** Composant optoélectronique selon la revendication 12, présentant en outre au moins à chaque fois une couche injectant des trous et une couche injectant des électrons et au moins à chaque fois une couche transportant des trous et une couche transportant des électrons, la couche injectant des trous et la couche transportant des électrons étant appliquées entre l'anode et la cathode et la couche transportant des trous et la couche transportant des électrons étant appliquées entre la couche injectant des trous et la couche injectant des électrons et la couche électroluminescente étant appliquée entre la couche transportant des trous et la couche transportant des électrons.

**14.** Matériau électroluminescent, présentant un composé selon la formule 1 et un matériau hôte, les niveaux d'énergie triplet (T1) et singulet (S1) du matériau hôte étant énergétiquement supérieurs aux niveaux d'énergie triplet (T1) et singulet (S1) du composé selon la formule 1 et le matériau électroluminescent émettant de la fluorescence ou de la fluorescence retardée, thermiquement activée et présentant une valeur deltaE(S1-T1) entre l'état de singulet excité le plus inférieur (S1) et l'état de triplet (T1) inférieur à celui-ci de moins de 2000 $cm^{-1}$

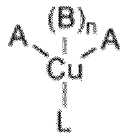

Formule 1

avec L : ligand selon la sous-formule 1

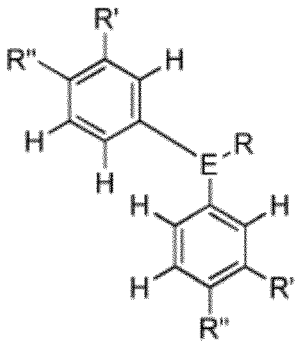

Sous-formule 1

avec E : arsenic ou phosphore

avec R : R représente, en chaque occurrence, de manière identique ou différente, H, D, un autre cycle phényle ou hétéroaryle substitué en position méta par R' et éventuellement substitué en position para par R", tel que la pyridine, un groupe alkyle, alcoxy ou thioalkyle linéaire, comprenant 1 à 8 atomes de carbone, ou un groupe alkyle, alcoxy ou thioalkyle ramifié ou cyclique comprenant 3 à 8 atomes de carbone, ou un groupe alcényle ou alcynyle comprenant 2 à 8 atomes de carbone, les groupes susmentionnés pouvant à chaque fois être substitués par un ou plusieurs radicaux R" et un ou plusieurs groupes $CH_2$ dans les groupes susmentionnés pouvant être remplacés par $-R^3C=CR^3-$, -C≡C-, $Si(R^3)_2$, C=O, C=S, $C=NR^3$, -C(=O)O-, $-C(=O)NR^3-$, $NR^3$, $P(=O)(R^3)$, -O-, -S-, SO ou $SO_2$ et un ou plusieurs atomes de H dans les groupes susmentionnés pouvant être remplacés par D, ou un système cyclique aromatique comprenant 6 à 30 atomes de cycle aromatique, qui peut à chaque fois être substitué par un ou plusieurs radicaux R'", ou un groupe aryloxy comprenant 6 à 30 atomes de cycle aromatique qui peut être substitué par un ou plusieurs radicaux R'" ;
avec R' : R' représente, en chaque occurrence, de manière identique ou différente, méthyle, éthyle, n-propyle, i-propyle, t-butyle, n-butyle, i-butyle, s-butyle ;
avec R" : R" représente en chaque occurrence, de manière identique ou différente, H, D, un groupe alkyle, alcoxy ou thioalkyle linéaire comprenant 1 à 8 atomes de carbone ou un groupe alkyle, alcoxy ou thioalkyle ramifié ou cyclique comprenant 3 à 8 atomes de carbone ou un groupe alcényle ou alcynyle comprenant 2 à 8 atomes de carbone, phényle, pyridyle, aryle ; avec R'" : représente en chaque occurrence, de manière identique ou différente, H, alkyle ou aryle ;
avec $R^3$ : représente en chaque occurrence, de manière identique ou différente, H, alkyle ou aryle ;
avec n = 0 ou 1 ;
avec A, B : un atome donneur sélectionné indépendamment l'un de l'autre, neutre ou mono-anionique, coordinant, choisi dans la liste N, P, As, S, O, F, Cl, Br, I, pseudohalogénure, qui peut éventuellement également faire partie d'un ligand formant un pont ou polydentate chélatant et, en présence de B, le complexe de cuivre CuLAAB étant coordiné de manière tétraédrique ou pseudotétraédrique et, en l'absence de B, le complexe de cuivre résultant CuLAA présentant une géométrie trigonale planaire déformée.

**15.** Procédé pour la fabrication d'un composant optoélectronique, un complexe de cuivre (I) de formule 1

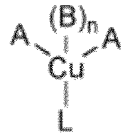

Formule 1

avec L : ligand selon la sous-formule 1

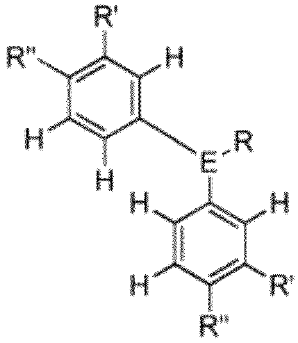

Sous-formule 1

avec E : arsenic ou phosphore
avec R : R représente, en chaque occurrence, de manière identique ou différente, H, D, un autre cycle phényle ou hétéroaryle substitué en position méta par R' et éventuellement substitué en position para par R", tel que la pyridine, un groupe alkyle, alcoxy ou thioalkyle linéaire, comprenant 1 à 8 atomes de carbone, ou un groupe alkyle, alcoxy ou thioalkyle ramifié ou cyclique comprenant 3 à 8 atomes de carbone, ou un groupe alcényle ou alcynyle comprenant 2 à 8 atomes de carbone, les groupes susmentionnés pouvant à chaque fois être

substitués par un ou plusieurs radicaux R" et un ou plusieurs groupes $CH_2$ dans les groupes susmentionnés pouvant être remplacés par $-R^3C=CR^3-$, -C≡C-, $Si(R^3)_2$, C=O, C=S, $C=NR^3$, -C(=O)O-, $-C(=O)NR^3-$, $NR^3$, $P(=O)(R^3)$, -O-, -S-, SO ou $SO_2$ et un ou plusieurs atomes de H dans les groupes susmentionnés pouvant être remplacés par D, ou un système cyclique aromatique comprenant 6 à 30 atomes de cycle aromatique, qui peut à chaque fois être substitué par un ou plusieurs radicaux R'", ou un groupe aryloxy comprenant 6 à 30 atomes de cycle aromatique qui peut être substitué par un ou plusieurs radicaux R'" ;

avec R' : R' représente, en chaque occurrence, de manière identique ou différente, méthyle, éthyle, n-propyle, i-propyle, t-butyle, n-butyle, i-butyle, s-butyle ;

avec R" : R" représente en chaque occurrence, de manière identique ou différente, H, D, un groupe alkyle, alcoxy ou thioalkyle linéaire comprenant 1 à 8 atomes de carbone ou un groupe alkyle, alcoxy ou thioalkyle ramifié ou cyclique comprenant 3 à 8 atomes de carbone ou un groupe alcényle ou alcynyle comprenant 2 à 8 atomes de carbone, phényle, pyridyle, aryle ; avec R'" : représente en chaque occurrence, de manière identique ou différente, H, alkyle ou aryle ;

avec $R^3$ : représente en chaque occurrence, de manière identique ou différente, H, alkyle ou aryle ;

avec n = 0 ou 1 ;

avec A, B : un atome donneur sélectionné indépendamment l'un de l'autre, neutre ou mono-anionique, coordinant, choisi dans la liste N, P, As, S, O, F, Cl, Br, I, pseudohalogénure, qui peut éventuellement également faire partie d'un ligand formant un pont ou polydentate chélatant et, en présence de B, le complexe de cuivre CuLAAB étant coordiné de manière tétraédrique ou pseudotétraédrique et, en l'absence de B, le complexe de cuivre résultant CuLAA présentant une géométrie trigonale planaire déformée.

**16.** Utilisation d'un complexe de cuivre (I) de formule 1, en particulier dans un composant optoélectronique, pour la conversion de rayonnement UV ou de lumière bleue en lumière visible, en particulier en lumière verte, jaune ou rouge (conversion vers le bas)

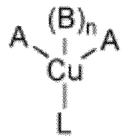

Formule 1

avec L : ligand selon la sous-formule 1

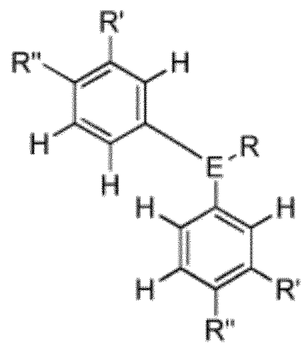

Sous-formule 1

avec E : arsenic ou phosphore ;

avec R : R représente, en chaque occurrence, de manière identique ou différente, H, D, un autre cycle phényle ou hétéroaryle substitué en position méta par R' et éventuellement substitué en position para par R", tel que la pyridine, un groupe alkyle, alcoxy ou thioalkyle linéaire, comprenant 1 à 8 atomes de carbone, ou un groupe alkyle, alcoxy ou thioalkyle ramifié ou cyclique comprenant 3 à 8 atomes de carbone, ou un groupe alcényle ou alcynyle comprenant 2 à 8 atomes de carbone, les groupes susmentionnés pouvant à chaque fois être substitués par un ou plusieurs radicaux R" et un ou plusieurs groupes $CH_2$ dans les groupes susmentionnés pouvant être remplacés par $-R^3C=CR^3-$, -C≡C-, $Si(R^3)_2$, C=O, C=S, $C=NR^3$, -C(=O)O-, $-C(=O)NR^3-$, $NR^3$,

$P(=O)(R^3)$, -O-, -S-, SO ou $SO_2$ et un ou plusieurs atomes de H dans les groupes susmentionnés pouvant être remplacés par D, ou un système cyclique aromatique comprenant 6 à 30 atomes de cycle aromatique, qui peut à chaque fois être substitué par un ou plusieurs radicaux R’", ou un groupe aryloxy comprenant 6 à 30 atomes de cycle aromatique qui peut être substitué par un ou plusieurs radicaux R’" ;
avec R’ : R’ représente, en chaque occurrence, de manière identique ou différente, méthyle, éthyle, n-propyle, i-propyle, t-butyle, n-butyle, i-butyle, s-butyle ;
avec R" : R" représente en chaque occurrence, de manière identique ou différente, H, D, un groupe alkyle, alcoxy ou thioalkyle linéaire comprenant 1 à 8 atomes de carbone ou un groupe alkyle, alcoxy ou thioalkyle ramifié ou cyclique comprenant 3 à 8 atomes de carbone ou un groupe alcényle ou alcynyle comprenant 2 à 8 atomes de carbone, phényle, pyridyle, aryle ; avec R’" : représente en chaque occurrence, de manière identique ou différente, H, alkyle ou aryle ;
avec $R^3$ : représente en chaque occurrence, de manière identique ou différente, H, alkyle ou aryle ;
avec n = 0 ou 1 ;
avec A, B : un atome donneur sélectionné indépendamment l’un de l’autre, neutre ou mono-anionique, coordinant, choisi dans la liste N, P, As, S, O, F, Cl, Br, I, pseudohalogénure, qui peut éventuellement également faire partie d’un ligand formant un pont ou polydentate chélatant et, en présence de B, le complexe de cuivre CuLAAB étant coordiné de manière tétraédrique ou pseudotétraédrique et, en l’absence de B, le complexe de cuivre résultant CuLAA présentant en particulier une géométrie trigonale planaire déformée.

Figur 1

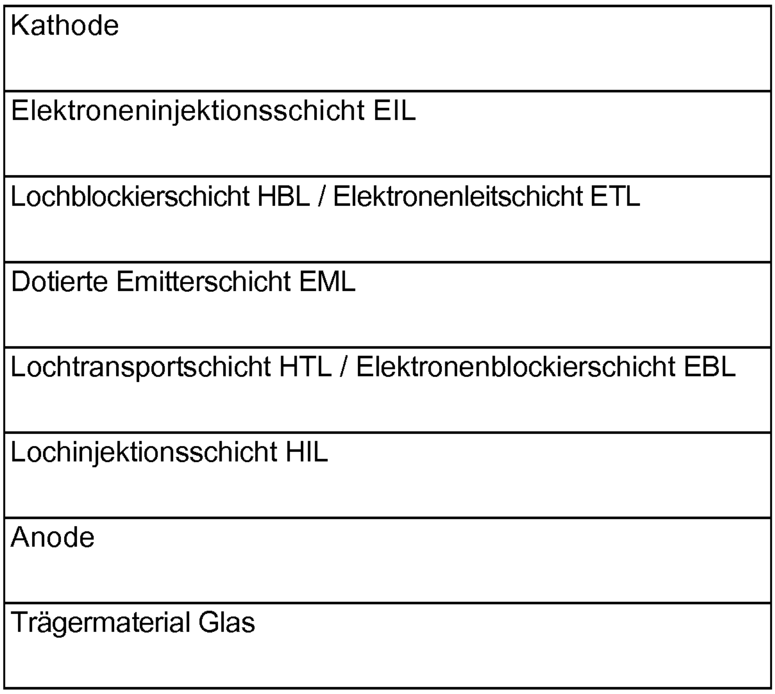
Kathode
Elektroneninjektionsschicht EIL
Lochblockierschicht HBL / Elektronenleitschicht ETL
Dotierte Emitterschicht EML
Lochtransportschicht HTL / Elektronenblockierschicht EBL
Lochinjektionsschicht HIL
Anode
Trägermaterial Glas

**Figur 2**

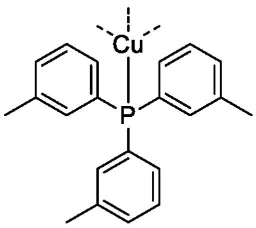

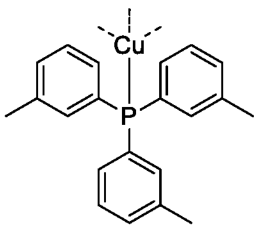

Weitere Konformere sind denkbar.

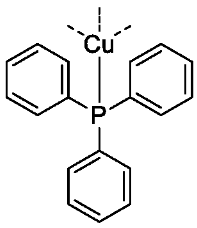

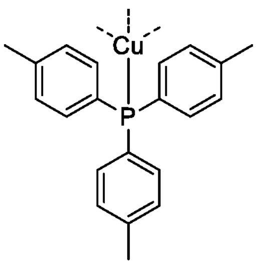

Keine weiteren Konformere!

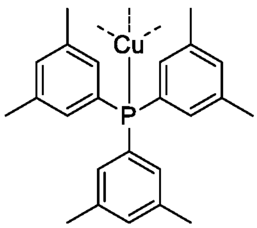

Figur 3

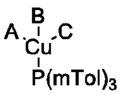

$2^3$ = 8 zusätzliche Freiheitsgrade im Vergleich zum $P(pTol)_3$-Derivat

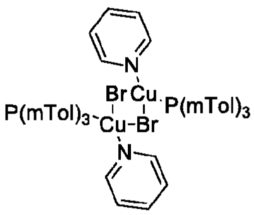

$2^6$ = 64 zusätzliche Freiheitsgrade im Vergleich zum $P(pTol)_3$-Derivat, die Hälfte davon sind aufgrund der Symmetrie (Inversionszentrum) äquivalent: 32 effektive zusätzliche Freiheitsgrade

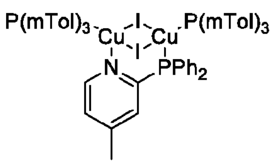

$2^6$ = 64 zusätzliche Freiheitsgrade im Vergleich zum $P(pTol)_3$-Derivat

Figur 4

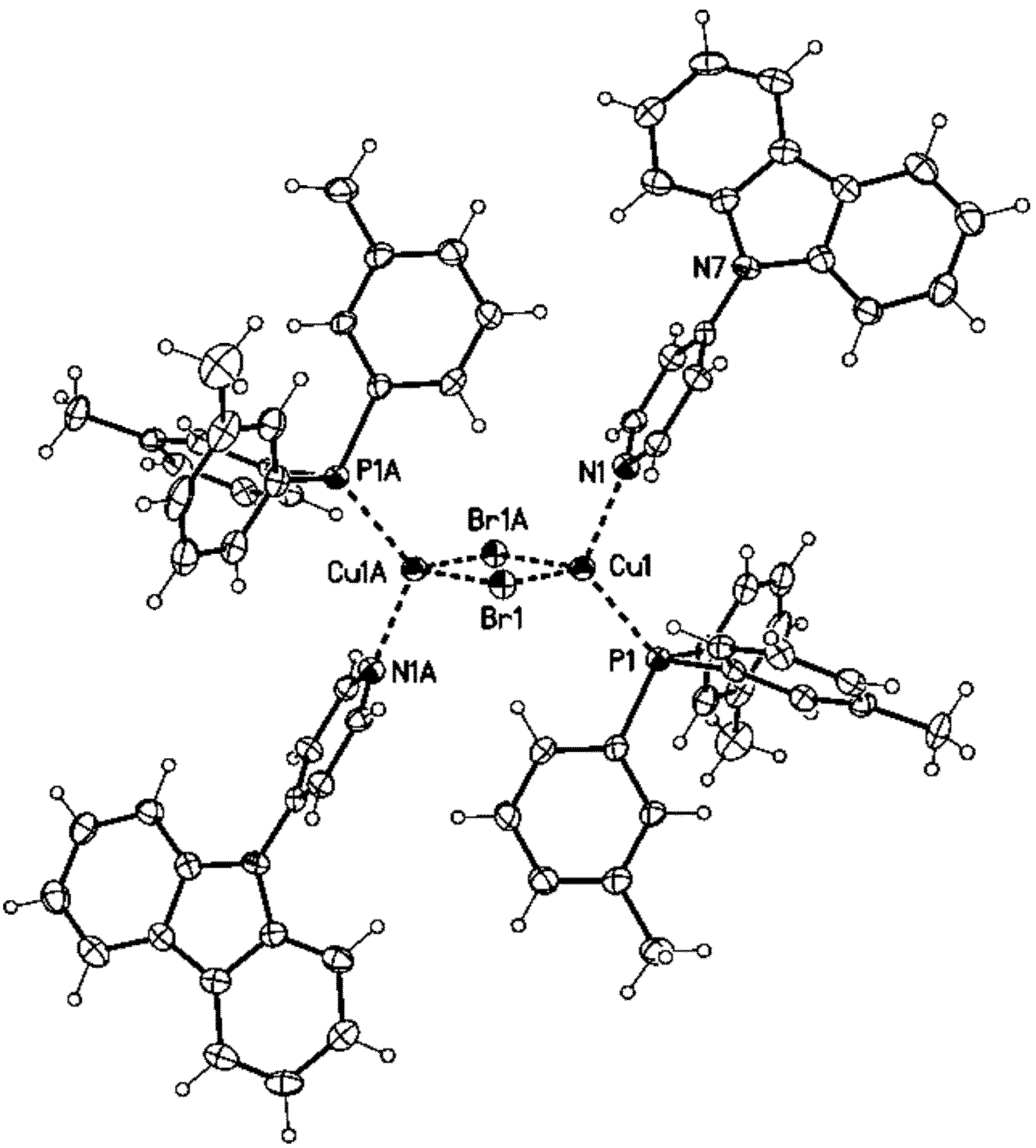

Figur 5

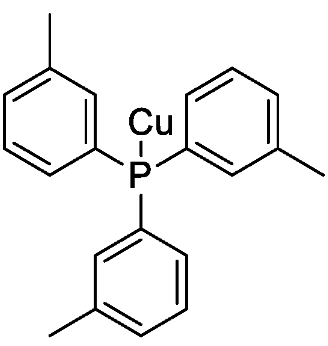

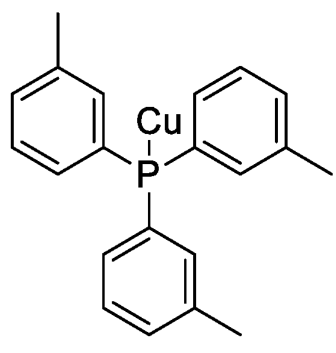

Figur 6

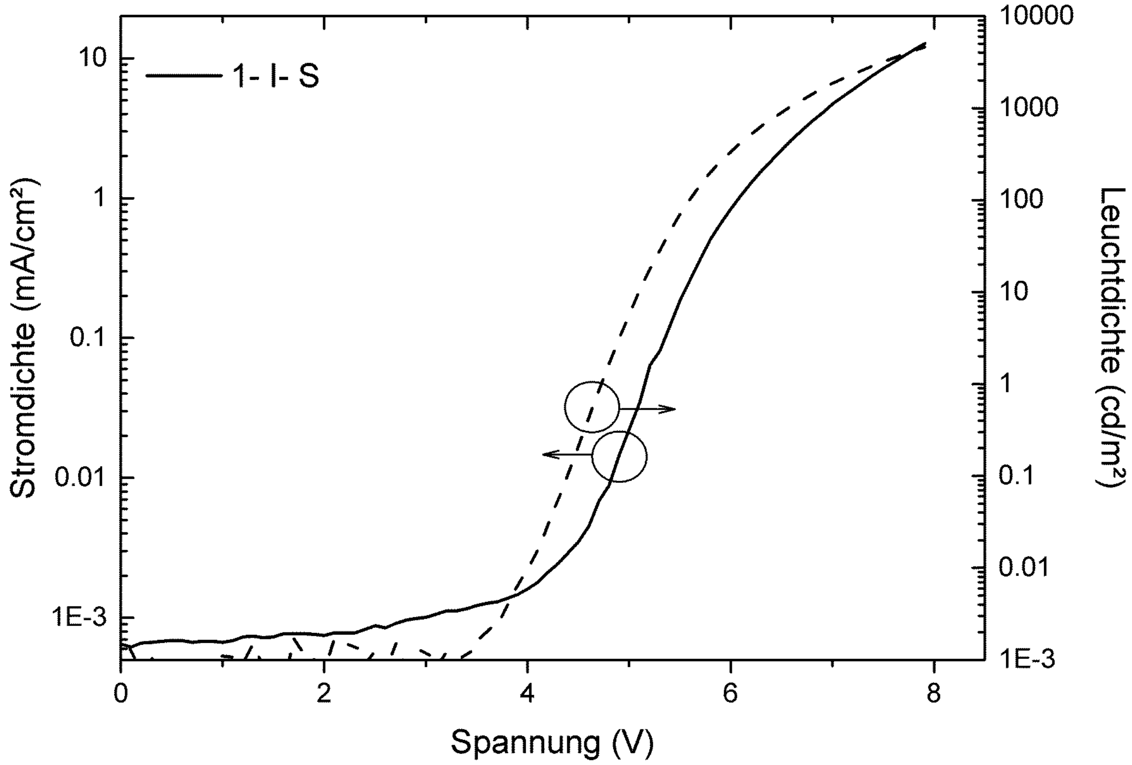
1- I- S
Stromdichte (mA/cm²)
Leuchtdichte (cd/m²)
Spannung (V)
10
1
0.1
0.01
1E-3
10000
1000
100
10
1
0.1
0.01
1E-3
0
2
4
6
8

**Figur 7**

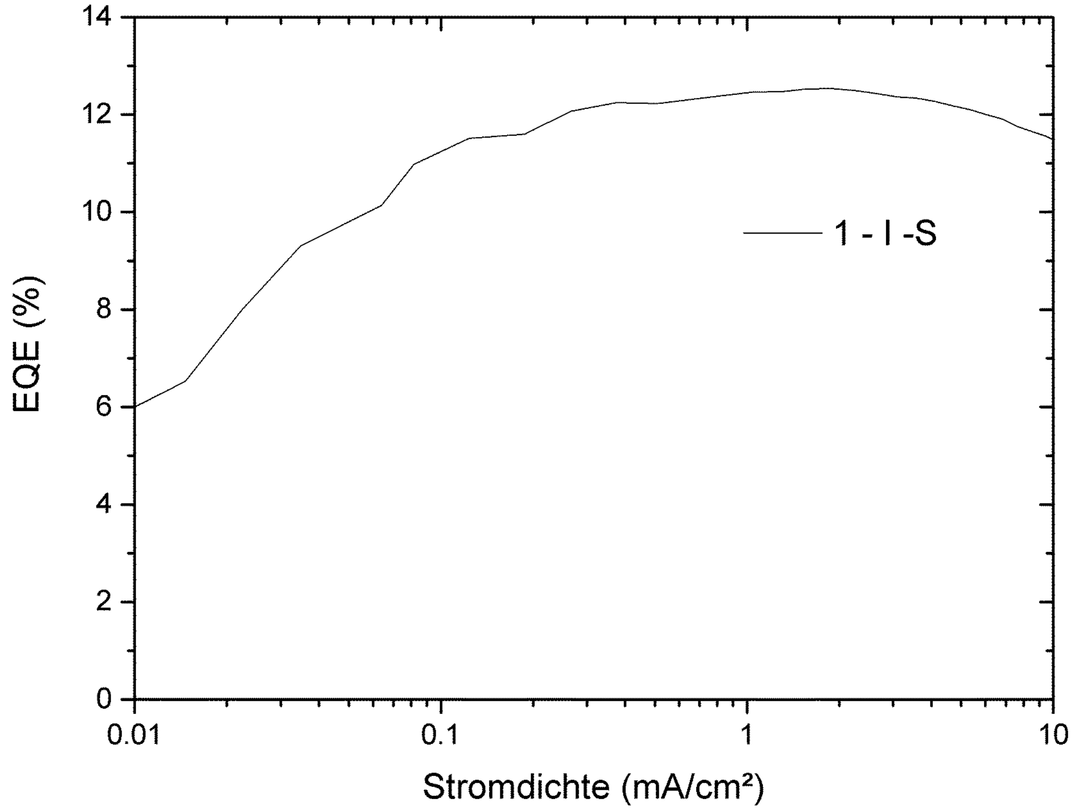

Figur 8

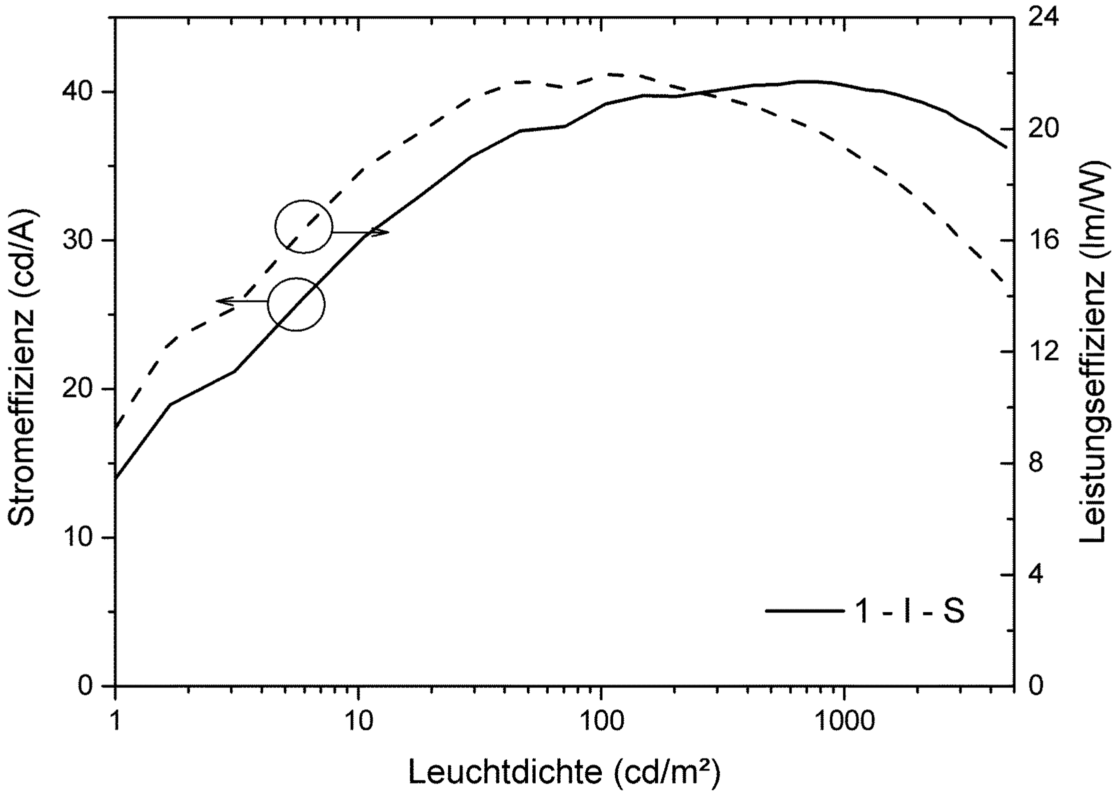
Stromeffizienz (cd/A)
Leistungseffizienz (lm/W)
Leuchtdichte (cd/m²)
1 - I - S
0
10
20
30
40
0
4
8
12
16
20
24
1
10
100
1000

Figur 9

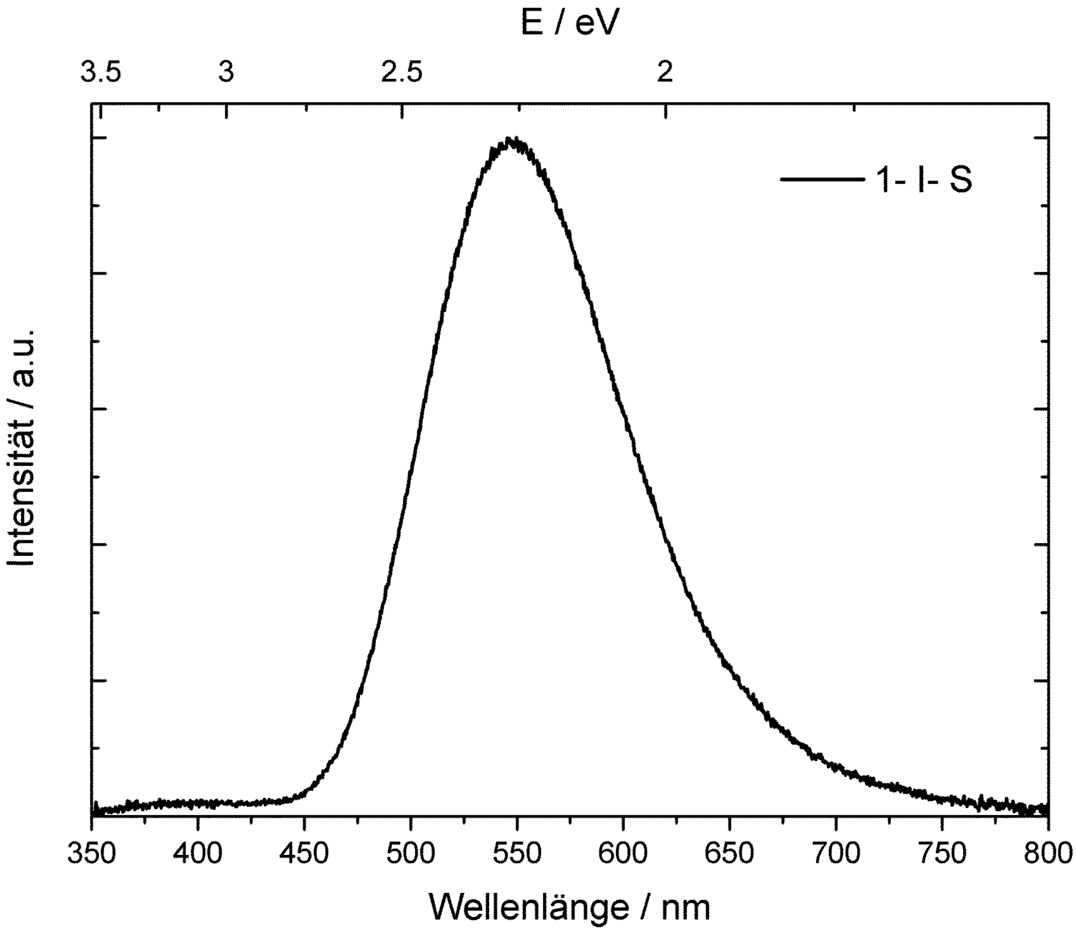
E / eV
3.5
3
2.5
2
1- I- S
Intensität / a.u.
350
400
450
500
550
600
650
700
750
800
Wellenlänge / nm

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- EP 2729477 A1
- EP 1911516 A1
- EP 2594571 A1
- EP 2554625 A1
- WO 05011013 A
- WO 04013080 A
- WO 04093207 A
- WO 06005627 A
- WO 05039246 A
- US 20050069729 A
- JP 2004288381 A
- EP 1205527 A
- WO 08086851 A
- WO 07063754 A
- WO 08056746 A
- EP 1617710 A
- EP 1617711 A
- EP 1731584 A
- JP 2005347160 A
- WO 07137725 A
- WO 05111172 A
- WO 06117052 A
- DE 102008036982 A1
- EP 652273 A
- DE 102007053771 A1
- DE 102008063470 A1


### In der Beschreibung aufgeführte Nicht-Patentliteratur


- **C. ADACHI et al.** *Appl. Phys. Lett.,* 2001, vol. 78, 1622
- **X. H. YANG et al.** *Appl. Phys. Lett.,* 2004, vol. 84, 2476
- **J. SHINAR (HRSG.** Organic light-emitting devices - A survey. AIP-Press, Springer, 2004
- **H. YERSIN.** *Top. Curr. Chem.,* 2004, vol. 241, 1
- **H. YERSIN.** Highly Efficient OLEDs with Phosphorescent Materials. Wiley-VCH, 2008
- **Z. H. KAFAFI.** Organic Electroluminescence. Taylor & Francis, 2005
- Preparation and spectral studies of dinuclear mixed-ligand copper(I) complexes. The crystal structure of bis[mu-s(pyridine-2-thione)(tmtp) copper(I) bromide. **ASLANIDIS P et al.** POLYHEDRON. PERGAMON PRESS, 01. November 1994, vol. 13, 3119-3125
- The crystal structure of mono- and di-nuclear copper(I) complexes with substituted triphenylphosphine ligands. **ESPINOZA SULLY et al.** POLYHEDRON. PERGAMON PRESS, OXFORD, 04. September 2014, vol. 85, 405-411
- **M. S. ARNOLD et al.** *Appl. Phys. Lett.,* 2008, vol. 92, 053301
- **VOLZ, D. ; ZINK, D. M. ; BOCKSROCKER, T. ; FRIEDRICHS, J. ; NIEGER, M. ; BAUMANN, T. ; LEMMER, U. ; BRÄSE, S.** *Chem. Mater.,* 2013, vol. 25, 3414
- **BECKE, A. D.** *Phys. Rev.,* vol. A1988 (38), 3098-3100
- **PERDEW, J. P.** *Phys. Rev. B,* 1986, vol. 33, 8822-8827
- **WEIGEND, F. ; AHLRICHS, R.** *Phys. Chem. Chem. Phys.,* 2005, vol. 7, 3297-3305
- **RAPPOPORT, D. ; FURCHE, F.** *J. Chem. Phys.,* 2010, vol. 133, 134105, , 1-134105, 11
- **HÄSER, M. ; AHLRICHS, R.** *J. Comput. Chem.,* 1989, vol. 10, 104-111
- **WEIGEND, F. ; HÄSER, M.** *Theor. Chem. Acc.,* 1997, vol. 97, 331-340
- **SIERKA, M. ; HOGEKAMP, A. ; AHLRICHS, R.** *J. Chem. Phys.,* 2003, vol. 118, 9136-9148